# EUROPEAN PATENT APPLICATION

(11) **EP 4 362 634 A2**
(43) Date of publication of application: **01.05.2024**
(21) Application number: 23198933.6
(22) Date of filing: 21.09.2023
(51) Int. Cl.: H10K 59/122, H10K 59/80

(54) **DISPLAY DEVICE AND METHOD FOR FABRICATION THEREOF**

(30) Priority: 25.10.2022 KR 20220138434
(71) Applicant: Samsung Display Co., Ltd., Yongin-si, Gyeonggi-do 17113 (KR)
(72) Inventor: PARK, Joon Yong, Yongin-si (KR); SHIN, Hyun Eok, Yongin-si (KR); LEE, Dong Min, Yongin-si (KR)
(74) Representative: Marks & Clerk LLP

(57) **Abstract**

A display device includes first and second pixel electrodes (AE1, AE2) on a substrate (SUB) to be spaced apart from each other, an inorganic insulating layer (ISL) on the substrate (SUB) to partially cover the first pixel electrode (AE1) and the second pixel electrode (AE2), a bank structure (BNS) on the inorganic insulating layer (ISL), where first and second openings (OPE1, OPE2) overlapping the first and second pixel electrodes (AE1, AE2) are defined through the bank structure (BNS), first and second light emitting layers (EL1, EL2) on the first and second pixel electrodes (AE1, AE2), and first and second common electrodes (CE1, CE2) on the first and second light emitting layers (EL1, EL2). The bank structure (BNS) includes first and second bank layers (BN1, BN2) including different organic insulating materials from each other, the second bank layer (BN2) has different thicknesses depending on positions thereof, the second bank layer (BN2) includes tips protruding more than side surfaces of the first bank layer (BN1) defining the first and second openings (OPE1, OPE2), and the first bank layer (BN1) includes AlNiLaCu.

## Description

### BACKGROUND

### 1. Field

The disclosure relates to a display device and a method for fabrication thereof.

### 2. Description of the Related Art

As the information society develops, the demand for display devices for displaying images has increased and diversified. For example, display devices have been applied to various electronic devices such as smartphones, digital cameras, laptop computers, navigation devices, and smart televisions. The display devices may be flat panel display devices such as liquid crystal display devices, field emission display devices, or organic light emitting display devices. Among such flat panel display devices, a light emitting display device may display an image without using a backlight unit for providing light to a display panel because each of the pixels of the display panel includes light emitting elements that may emit light by themselves.

### SUMMARY

Embodiments of the present disclosure provide a display device capable of forming separate light emitting elements for each emission area without a mask process.

Embodiments of the disclosure also provide a display device in which an emission deviation that may occur for each pixel is reduced even though a portion of a bank structure is damaged by an etching process performed during processes for fabrication of the display device.

However, embodiments of the disclosure are not limited to those set forth herein. The above and other features of embodiments of the disclosure will become more apparent to one of ordinary skill in the art to which the disclosure pertains by referencing the detailed description of the disclosure given below.

According to an embodiment of the disclosure, a display device includes a first pixel electrode and a second pixel electrode which are disposed on a substrate to be spaced apart from each other, an inorganic insulating layer disposed on the substrate to partially cover the first pixel electrode and the second pixel electrode, a bank structure disposed on the inorganic insulating layer, where a first opening overlapping the first pixel electrode and a second opening overlapping the second pixel electrode are defined through the bank structure, a first light emitting layer disposed on the first pixel electrode and a second light emitting layer disposed on the second pixel electrode, and a first common electrode disposed on the first light emitting layer and a second common electrode disposed on the second light emitting layer, where the bank structure includes a first bank layer and a second bank layer disposed on the first bank layer, the second bank layer includes an organic insulating material different from a material of the first bank layer to have different thicknesses depending on positions thereof, the second bank layer includes tips protruding more than side surfaces of the first bank layer defining the first opening and the second opening, and the first bank layer includes an aluminium (Al)-nickel (Ni)-lanthanum (La)-copper (Cu) alloy (AlNiLaCu).

In an embodiment, the first common electrode and the second common electrode may be in direct contact with the side surfaces of the first bank layer, respectively.

In an embodiment, the first bank layer may include metal oxide films formed at the side surfaces thereof defining the first opening and the second opening, and the metal oxide films may include metal crystals formed at surfaces thereof and including an aluminium (Al)-nickel (Ni)-copper (Cu) alloy.

In an embodiment, the second bank layer may include a first bank part positioned around the first opening and a second bank part positioned around the second opening, and the first bank part may have a thickness greater than a thickness of the second bank part.

In an embodiment, a tip of the second bank layer corresponding to the first opening may have a thickness greater than a thickness of a tip of the second bank layer corresponding to the second opening.

In an embodiment, the display device may further include a third pixel electrode disposed to be spaced apart from the second pixel electrode on the substrate, a third light emitting layer disposed on the third pixel electrode, and a third common electrode disposed on the third light emitting layer, where a third opening overlapping the third pixel electrode may be further defined in the bank structure, and the second bank layer may further include a third bank part positioned around the third opening and having a thickness less than a thickness of the second bank part.

In an embodiment, a thickness difference between the first bank part and the second bank part may be substantially the same as a thickness difference between the second bank part and the third bank part.

In an embodiment, the second bank layer may further include fourth bank parts disposed between the first bank part, the second bank part, and the third bank part and having a thickness less than the thickness of the third bank part.

In an embodiment, the display device may further include a first organic pattern disposed on the first bank part and including a same material as the first light emitting layer, a first electrode pattern disposed on the first organic pattern and including a same material as the first common electrode, a second organic pattern disposed on the second bank part and including a same material as the second light emitting layer, and a second electrode pattern disposed on the second organic pattern and including a same material as the second common electrode.

In an embodiment, the display device may further include a first inorganic layer disposed on the side surfaces of the first bank layer defining the first opening and disposed on the first common electrode and the first electrode pattern and a second inorganic layer disposed on the side surfaces of the first bank layer defining the second opening and disposed on the second common electrode and the second electrode pattern, where the first inorganic layer and the second inorganic layer may be disposed to be spaced apart from each other, and portions of the second bank layer may not overlap the first inorganic layer and the second inorganic layer.

In an embodiment, the inorganic insulating layer may not be in contact with each of upper surfaces of the first pixel electrode and the second pixel electrode, a portion of the first light emitting layer may be disposed between the first pixel electrode and the inorganic insulating layer, and a portion of the second light emitting layer may be disposed between the second pixel electrode and the inorganic insulating layer.

In an embodiment, the display device may further include residual patterns disposed between the first pixel electrode and the inorganic insulating layer and between the second pixel electrode and the inorganic insulating layer.

In an embodiment, the display device may further include a thin film encapsulation layer disposed on the bank structure, wherein the thin film encapsulation layer may include a first encapsulation layer, a second encapsulation layer disposed on the first encapsulation layer, and a third encapsulation layer disposed on the second encapsulation layer.

In an embodiment, the display device may further include a light blocking layer disposed on the third encapsulation layer, where a plurality of opening holes overlapping the first and second openings may be defined through the light blocking layer, a first color filter disposed on the light blocking layer and overlapping the first opening, and a second color filter disposed on the light blocking layer and overlapping the second opening.

According to an embodiment of the disclosure, a method for fabrication of a display device includes forming a plurality of pixel electrodes spaced apart from each other on a substrate, forming a sacrificial layer on the pixel electrodes, forming an inorganic insulating layer on the sacrificial layer, forming a first bank material layer on the inorganic insulating layer, and forming an organic insulating layer on the first bank material layer, forming a second bank material layer on the first bank material layer by baking the organic insulating layer, forming a first hole through the first bank material layer and the second bank material layer to expose the sacrificial layer disposed on a pixel electrode of the pixel electrodes, wet-etching the sacrificial layer and side surfaces of the first bank material layer and the second bank material layer defining the first hole to remove the sacrificial layer and to form a tip of the second bank material layer protruding more than an etched side surface of the first bank material layer, forming a light emitting layer and a common electrode disposed on the pixel electrode in a first opening formed by wet-etching the first hole and forming an inorganic layer on the common electrode and the second bank material layer, and removing a portion of the inorganic layer disposed on the second bank material layer, where in the removing the portion of the inorganic layer, a portion of the second bank material layer is etched to have a decreased thickness.

In an embodiment, the first bank material layer may include an aluminium (Al)-nickel (Ni)-lanthanum (La)-copper (Cu) alloy (AlNiLaCu), and the second bank material layer may include an organic insulating material.

In an embodiment, a process of baking the organic insulating layer may be performed in a temperature range of about 200 °C to about 300 °C for 30 minutes to 2 hours.

In an embodiment, the first bank material layer may include a metal oxide film formed at a side surface thereof defining the first opening, and the metal oxide film may include metal crystals formed at a surface thereof and including an alumin.um (Al)-nickel (Ni)-copper (Cu) alloy.

In an embodiment, in the forming the light emitting layer and the common electrode, an organic pattern including a same material as the light emitting layer may be formed on the second bank material layer, and an electrode pattern including a same material as the common electrode may be formed on the organic pattern, and the inorganic layer may be disposed on the electrode pattern.

In an embodiment, the second bank material layer may include a bank part overlapping the organic pattern and the electrode pattern and a residual portion which is a portion other than the bank part and exposed by removing a portion of the inorganic layer, and in the removing of the portion of the inorganic layer, the residual portion may be etched to have a thickness less than a thickness of the bank part.

At least some of the above and other features of the invention are set out in the claims.

A display device according to embodiments may have a structure in which a bank structure forming emission areas has a sufficient thickness even though the bank structure is partially damaged in processes for fabrication of a display device. Accordingly, in the display device, it is possible to prevent tips formed in openings of the bank structure from sagging, and respective light emitting elements may have uniform luminance to prevent the occurrence of a mura (or mura effect) in the display device.

### BRIEF DESCRIPTION OF THE DRAWINGS

The above and other features of embodiments of the disclosure will become more apparent by describing in detail embodiments thereof with reference to the accompanying drawings, in which:
FIG. 1 is a schematic perspective view of an electronic device according to an embodiment;
FIG. 2 is a perspective view illustrating a display device included in the electronic device according to an embodiment;
FIG. 3 is a cross-sectional view of the display device of FIG. 2 viewed from a side;
FIG. 4 is a plan view illustrating a display layer of the display device according to an embodiment;
FIG. 5 is a cross-sectional view illustrating a portion of the display device according to an embodiment;
FIG. 6 is an enlarged view illustrating a first emission area of FIG. 5;
FIG. 7 is an enlarged view illustrating a second emission area and a third emission area of FIG. 5;
FIG. 8 is an enlarged view illustrating a side surface of a first bank layer in a bank structure of the display device according to an embodiment;
FIG. 9 is a schematic view illustrating a surface layer formed on a surface of the first bank layer of FIG. 8; and
FIGS. 10 to 19 are cross-sectional views sequentially illustrating processes for fabrication of the display device according to an embodiment.

### DETAILED DESCRIPTION

The invention will now be described more fully hereinafter with reference to the accompanying drawings, in which various embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will also be understood that when a layer is referred to as being "on" another layer or substrate, it can be directly on the other layer or substrate, or intervening layers may also be present. In contrast, when an element is referred to as being "directly on" another element, there are no intervening elements present.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings of the invention. Similarly, the second element could also be termed the first element.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments will be described with reference to the accompanying drawings.

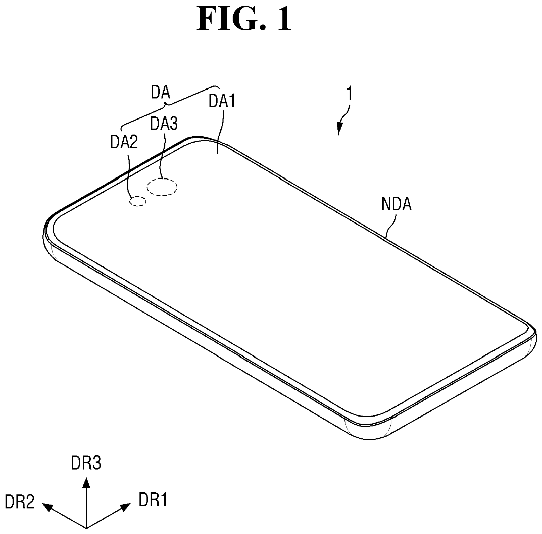

FIG. 1 is a schematic perspective view of an electronic device according to an embodiment.

Referring to FIG. 1, an electronic device 1 displays a moving image or a still image. The electronic device 1 may refer to all electronic devices that provide display screens, for example, televisions, laptop computers, monitors, billboards, the Internet of Things (IoT), mobile phones, smartphones, tablet personal computers (PCs), electronic watches, smart watches, watch phones, head mounted displays, mobile communication terminals, electronic notebooks, electronic books, portable multimedia players (PMPs), navigation devices, game machines, digital cameras, camcorders, and the like.

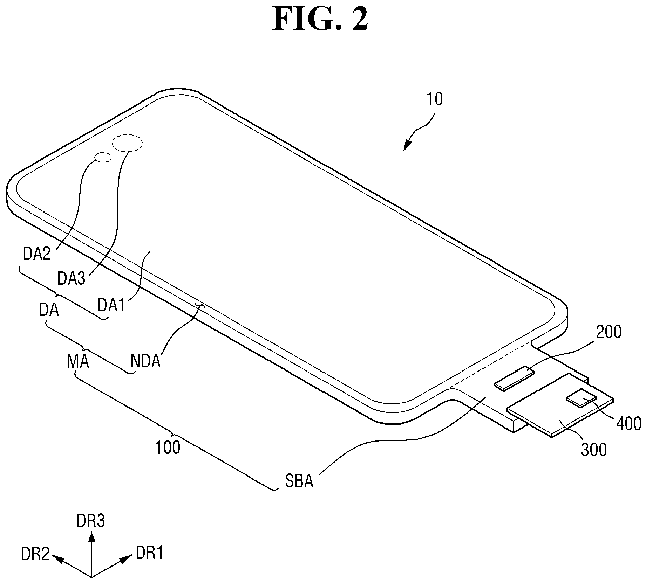

The electronic device 1 may include a display device 10 (see FIG. 2) that provides a display screen. Examples of the display device may include an inorganic light emitting diode display device, an organic light emitting display device, a quantum dot light emitting display device, a plasma display device, a field emission display device, and the like. Hereinafter, embodiments where the display device is an inorganic light emitting diode display device will be described by way of example, but the disclosure is not limited thereto, and the same technical idea may be applied to other display devices if applicable.

A shape of the electronic device 1 may be variously modified. In an embodiment, for example, the electronic device 1 may have a shape such as a rectangular shape with a width greater than a length, a rectangular shape with a length greater than a width, a square shape, a rectangular shape with rounded corners (vertices), other polygonal shapes, or a circular shape. A shape of a display area DA of the electronic device 1 may also be similar to an overall shape of the electronic device 1. In FIG. 1, an embodiment of the electronic device 1 having a rectangular shape with a greater length in a second direction DR2 is illustrated.

The electronic device 1 may include a display area DA and a non-display area NDA. The display area DA is an area in which an image may be displayed, and the non-display area NDA is an area in which the image is not displayed. The display area DA may also be referred to as an active area, and the non-display area NDA may also be referred to as a non-active area. The display area DA may occupy substantially the center of the electronic device 1.

The display area DA may include a first display area DA1, a second display area DA2, and a third display area DA3. The second display area DA2 and the third display area DA3 may be areas in which components for adding various functions to the electronic device 1 are disposed, and may correspond to component areas.

FIG. 2 is a perspective view illustrating a display device included in the electronic device according to an embodiment.

Referring to FIG. 2, the electronic device 1 according to an embodiment may include a display device 10. The display device 10 may provide a screen in which an image is displayed by the electronic device 1. The display device 10 may have a shape similar to that of the electronic device 1 in a plan view. In an embodiment, for example, the display device 10 may have a shape similar to a rectangular shape having short sides in a first direction DR1 and long sides in the second direction DR2. A corner where the short side in the first direction DR1 and the long side in the second direction DR2 meet may be rounded with a curvature, but is not limited thereto, and may also be right-angled. The shape of the display device 10 in a plan view is not limited to the rectangular shape, and may be a shape similar to other polygonal shapes, a circular shape, or an elliptical shape.

The display device 10 may include a display panel 100, a display driver 200, a circuit board 300, and a touch driver 400.

The display panel 100 may include a main area MA and a sub-area SBA.

The main area MA may include a display area DA including pixels displaying an image and a non-display area NDA disposed around the display area DA. The display area DA may include a first display area DA1, a second display area DA2, and a third display area DA3. The display area DA may emit light from a plurality of emission areas or a plurality of opening areas. In an embodiment, for example, the display panel 100 may include pixel circuits including switching elements, a pixel defining film defining the emission areas or opening areas, and self-light emitting elements.

In an embodiment, for example, the self-light emitting element may include at least one selected from an organic light emitting diode (LED) including an organic light emitting layer, a quantum dot LED including a quantum dot light emitting layer, an inorganic LED including an inorganic semiconductor, and a micro LED, but is not limited thereto.

The non-display area NDA may be an area outside the display area DA. The non-display area NDA may be defined as an edge area of the main area MA of the display panel 100. The non-display area NDA may include a gate driver (not illustrated) for supplying gate signals to gate lines, and fan-out lines (not illustrated) connecting the display driver 200 and the display area DA to each other.

The sub-area SBA may be an area extending from one side of the main area MA. The sub-area SBA may include a flexible material that may be bent, folded, and rolled. In an embodiment, for example, in a state where the sub-area SBA is bent, the sub-area SBA may overlap the main area MA in a thickness direction (a third direction DR3). The sub-area SBA may include the display driver 200 and pad parts connected to the circuit board 300. In an alternative embodiment, the sub-area SBA may be omitted, and the display driver 200 and the pad parts may be disposed in the non-display area NDA.

The display driver 200 may output signals and voltages for driving the display panel 100. The display driver 200 may supply data voltages to data lines. The display driver 200 may supply a source voltage to power lines and supply gate control signals to the gate driver. The display driver 200 may be formed as an integrated circuit (IC) and be mounted on the display panel 100 in a chip on glass (COG) manner, a chip on plastic (COP) manner, or an ultrasonic bonding manner. In an embodiment, for example, the display driver 200 may be disposed in the sub-area SBA, and may overlap the main area MA in the thickness direction by bending of the sub-area SBA. In an alternative embodiment, for example, the display driver 200 may be mounted on the circuit board 300.

The circuit board 300 may be attached onto the pad parts of the display panel 100 using an anisotropic conductive film (ACF). Lead lines of the circuit board 300 may be electrically connected to the pad parts of the display panel 100. The circuit board 300 may be a flexible printed circuit board, a printed circuit board, or a flexible film such as a chip on film.

The touch driver 400 may be mounted on the circuit board 300. The touch driver 400 may be connected to a touch sensing unit of the display panel 100. The touch driver 400 may supply touch driving signals to a plurality of touch electrodes of the touch sensing unit and sense change amounts in capacitance between the plurality of touch electrodes. In an embodiment, for example, the touch driving signal may be a pulse signal having a predetermined frequency. The touch driver 400 may decide whether or not an input has been generated and calculate input coordinates, based on the change amounts in capacitance between the plurality of touch electrodes. The touch driver 400 may be formed as an IC.

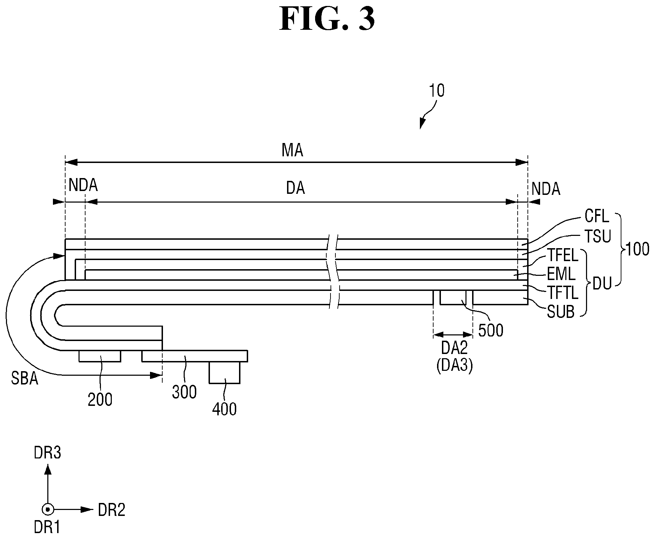

FIG. 3 is a cross-sectional view of the display device of FIG. 2 viewed from a side.

Referring to FIG. 3, in an embodiment, the display panel 100 may include a display layer DU, a touch sensing unit TSU, and a color filter layer CFL. The display layer DU may include a substrate SUB, a thin film transistor layer TFTL, a light emitting element layer EML, and a thin film encapsulation layer TFEL.

The substrate SUB may be a base substrate or a base member. The substrate SUB may be a flexible substrate that may be bent, folded, and rolled. In an embodiment, for example, the substrate SUB may include a polymer resin such as polyimide (PI), but is not limited thereto. In an alternative embodiment, the substrate SUB may include a glass material or a metal material.

The thin film transistor layer TFTL may be disposed on the substrate SUB. The thin film transistor layer TFTL may include a plurality of thin film transistors constituting pixel circuits of pixels. The thin film transistor layer TFTL may further include gate lines, data lines, power lines, gate control lines, fan-out lines connecting the display driver 200 and the data lines to each other, and lead lines connecting the display driver 200 and the pad parts to each other. Each of the thin film transistors may include a semiconductor region, a source electrode, a drain electrode, and a gate electrode. In an embodiment, for example, where the gate driver is formed on one side of the non-display area NDA of the display panel 100, the gate driver may include thin film transistors.

The thin film transistor layer TFTL may be disposed in the display area DA, the non-display area NDA, and the sub-area SBA. The thin film transistors of each of the pixels, the gate lines, the data lines, and the power lines of the thin film transistor layer TFTL may be disposed in the display area DA. The gate control lines and the fan-out lines of the thin film transistor layer TFTL may be disposed in the non-display area NDA. The lead lines of the thin film transistor layer TFTL may be disposed in the sub-area SBA.

The light emitting element layer EML may be disposed on the thin film transistor layer TFTL. The light emitting element layer EML may include a plurality of light emitting elements each including a first electrode, a second electrode, and a light emitting layer to emit light and a pixel defining film defining the pixels. The plurality of light emitting elements of the light emitting element layer EML may be disposed in the display area DA.

In an embodiment, the light emitting layer may be an organic light emitting layer including an organic material. The light emitting layer may include a hole transporting layer, an organic light emitting layer, and an electron transporting layer. When the first electrode receives a voltage through the thin film transistor of the thin film transistor layer TFTL and the second electrode receives a cathode voltage, holes and electrons may move to the organic light emitting layer through the hole transporting layer and the electron transporting layer, respectively, and may be combined with each other in the organic light emitting layer to emit light.

In an alternative embodiment, the light emitting element may include a quantum dot LED including a quantum dot light emitting layer, an inorganic LED including an inorganic semiconductor, or a micro LED.

The thin film encapsulation layer TFEL may cover an upper surface and side surfaces of the light emitting element layer EML, and may protect the light emitting element layer EML. The thin film encapsulation layer TFEL may include at least one inorganic film and at least one organic film for encapsulating the light emitting element layer EML.

The touch sensing unit TSU may be disposed on the thin film encapsulation layer TFEL. The color filter layer CFL may be disposed on the touch sensing unit TSU. The color filter layer CFL may include a plurality of color filters each corresponding to the plurality of emission areas. Each of the color filters may selectively transmit light of a specific wavelength therethrough and block or absorb light of other wavelengths. The color filter layer CFL may absorb some of the light introduced from the outside of the display device 10 to reduce reflected light by external light. Accordingly, the color filter layer CFL may prevent distortion of colors due to external light reflection.

Since the color filter layer CFL is directly disposed on the touch sensing unit TSU, the display device 10 may not include a separate substrate for the color filter layer CFL. Accordingly, a thickness of the display device 10 may be relatively small.

In some embodiments, the display device 10 may further include an optical device 500. The optical device 500 may be disposed in the second display area DA2 or the third display area DA3. The optical device 500 may emit or receive light of infrared, ultraviolet, or visible light bands. In an embodiment, for example, the optical device 500 may be an optical sensor sensing light incident on the display device 10, such as a proximity sensor, an illuminance sensor, and a camera sensor, or an image sensor.

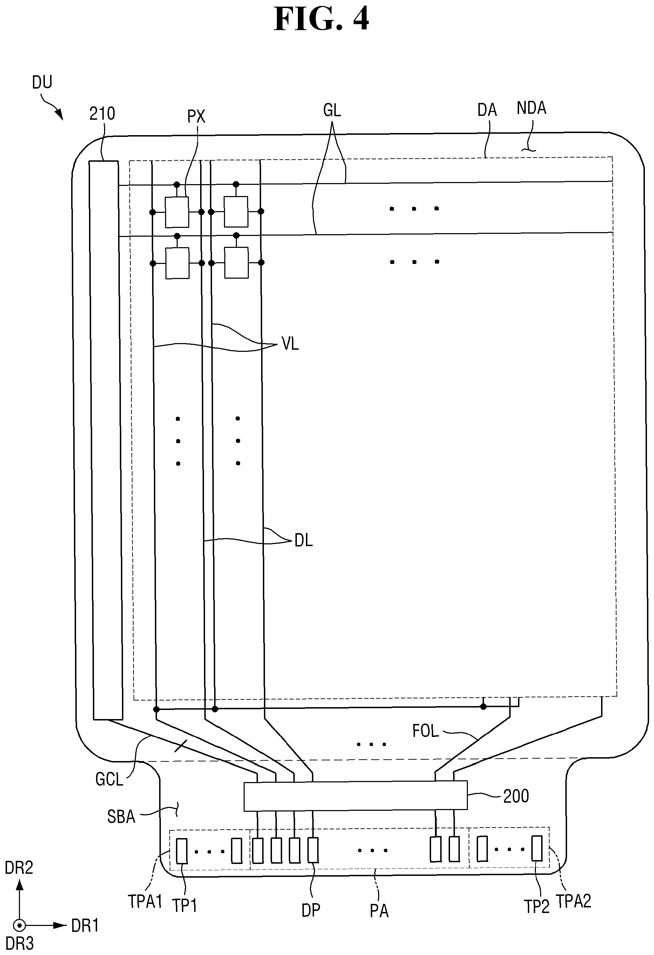

FIG. 4 is a plan view illustrating a display layer of the display device according to an embodiment.

Referring to FIG. 4, in an embodiment, the display layer DU may include a display area DA and a non-display area NDA.

The display area DA may be disposed at the center of the display panel 100. A plurality of pixels PX, a plurality of gate lines GL, a plurality of data lines DL, and a plurality of power lines VL may be disposed in the display area DA. Each of the plurality of pixels PX may be defined as a minimum unit for emitting light.

The plurality of gate lines GL may supply gate signals received from a gate driver 210 to the plurality of pixels PX. The plurality of gate lines GL may extend in the first direction DR1, and may be spaced apart from each other in the second direction DR2 crossing the first direction DR1.

The plurality of data lines DL may supply data voltages received from the display driver 200 to the plurality of pixels PX. The plurality of data lines DL may extend in the second direction DR2, and may be spaced apart from each other in the first direction DR1.

The plurality of power lines VL may supply a source voltage received from the display driver 200 to the plurality of pixels PX. Here, the source voltage may be at least one of a driving voltage, an initialization voltage, a reference voltage, and a low potential voltage. The plurality of power lines VL may extend in the second direction DR2, and may be spaced apart from each other in the first direction DR1.

The non-display area NDA may surround the display area DA. The gate driver 210, fan-out lines FOL, and gate control lines GCL may be disposed in the non-display area NDA. The gate driver 210 may generate a plurality of gate signals based on gate control signals, and may sequentially supply the plurality of gate signals to the plurality of gate lines GL according to a set order.

The fan-out lines FOL may extend from the display driver 200 to the display area DA. The fan-out lines FOL may supply the data voltages received from the display driver 200 to the plurality of data lines DL.

The gate control lines GCL may extend from the display driver 200 to the gate driver 210. The gate control lines GCL may supply the gate control signals received from the display driver 200 to the gate driver 210.

The sub-area SBA may include the display driver 200, a pad area PA, and first and second touch pad areas TPA1 and TPA2.

The display driver 200 may output signals and voltages for driving the display panel 100 to the fan-out lines FOL. The display driver 200 may supply the data voltages to the data lines DL through the fan-out lines FOL. The data voltages may be supplied to the plurality of pixels PX, and may control luminance of the plurality of pixels PX. The display driver 200 may supply the gate control signals to the gate driver 210 through the gate control lines GCL.

The pad area PA, the first touch pad area TPA1, and the second touch pad area TPA2 may be disposed at an edge of the sub-area SBA. The pad area PA, the first touch pad area TPA1, and the second touch pad area TPA2 may be electrically connected to the circuit board 300 using a material such as an anisotropic conductive film or a self assembly anisotropic conductive paste (SAP).

The pad area PA may include a plurality of display pad parts DP. The plurality of display pad parts DP may be connected to a graphic system through the circuit board 300. The plurality of display pad parts DP may be connected to the circuit board 300 to receive digital video data, and may supply the digital video data to the display driver 200.

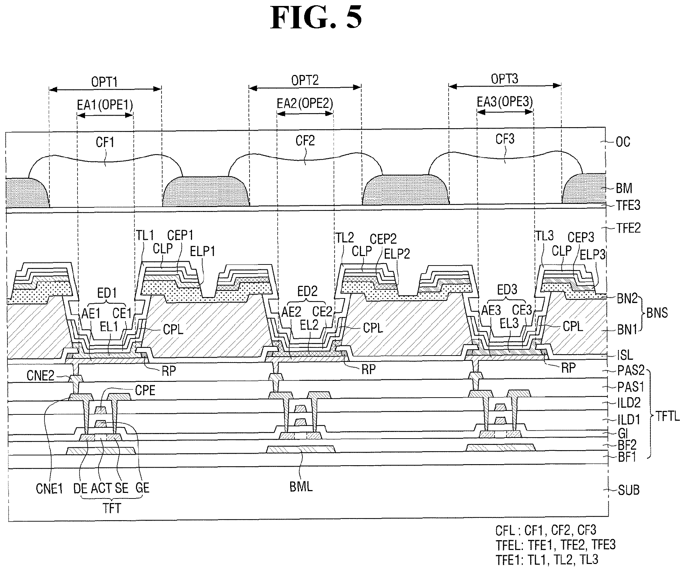

FIG. 5 is a cross-sectional view illustrating a portion of the display device according to an embodiment. FIG. 5 is a partial cross-sectional view of the display device 10, and illustrates cross sections of the substrate SUB, the thin film transistor layer TFTL, the light emitting element layer, and the thin film encapsulation layer TFEL of the display layer DU, and the color filter layer CFL.

Referring to FIG. 5, the display panel 100 of the display device 10 may include the display layer DU and the color filter layer CFL. The display layer DU may include the substrate SUB, the thin film transistor layer TFTL, the light emitting element layer, and the thin film encapsulation layer TFEL. The display panel 100 may include a light blocking layer BM disposed on the thin film encapsulation layer TFEL, and color filters CF1, CF2, and CF3 of the color filter layer CFL may be disposed on the light blocking layer BM.

The substrate SUB may be a base substrate or a base member. The substrate SUB may be a flexible substrate that may be bent, folded, and rolled. In an embodiment, for example, the substrate SUB may include a polymer resin such as polyimide (PI), but is not limited thereto. In an alternative embodiment, for example, the substrate SUB may include a glass material or a metal material.

The thin film transistor layer TFTL may include a first buffer layer BF1, a lower metal layer BML, a second buffer layer BF2, thin film transistors TFT, a gate insulating layer GI, a first interlayer insulating layer ILD1, capacitor electrodes CPE, a second interlayer insulating layer ILD2, first connection electrodes CNE1, a first passivation layer PAS1, second connection electrodes CNE2, and a second passivation layer PAS2.

The first buffer layer BF1 may be disposed on the substrate SUB. The first buffer layer BF1 may include an inorganic film capable of preventing penetration of air or moisture. In an embodiment, for example, the first buffer layer BF1 may include a plurality of inorganic films that are alternately stacked.

The lower metal layer BML may be disposed on the first buffer layer BF1. For example, the lower metal layer BML may be formed as (or defined by) a single layer or multiple layers including or made of at least one selected from molybdenum (Mo), aluminium (Al), chromium (Cr), gold (Au), titanium (Ti), nickel (Ni), neodymium (Nd), and copper (Cu), or alloys thereof.

The second buffer layer BF2 may cover the first buffer layer BF1 and the lower metal layer BML. The second buffer layer BF2 may include an inorganic film capable of preventing penetration of air or moisture. In an embodiment, for example, the second buffer layer BF2 may include a plurality of inorganic films that are alternately stacked.

The thin film transistor TFT may be disposed on the second buffer layer BF2, and may constitute a pixel circuit of each of the plurality of pixels. In an embodiment, for example, the thin film transistor TFT may be a driving transistor or a switching transistor of the pixel circuit. The thin film transistor TFT may include a semiconductor layer ACT, a source electrode SE, a drain electrode DE, and a gate electrode GE.

The semiconductor layer ACT may be disposed on the second buffer layer BF2. The semiconductor layer ACT may overlap the lower metal layer BML and the gate electrode GE in the thickness direction, and may be insulated from the gate electrode GE by the gate insulating layer GI. A material of the semiconductor layer ACT in portions of the semiconductor layer ACT may become conductors to form the source electrode SE and the drain electrode DE.

The gate electrode GE may be disposed on the gate insulating layer GI. The gate electrode GE may overlap the semiconductor layer ACT with the gate insulating layer GI interposed therebetween.

The gate insulating layer GI may be disposed on the semiconductor layer ACT. In an embodiment, for example, the gate insulating layer GI may cover the semiconductor layer ACT and the second buffer layer BF2, and may insulate the semiconductor layer ACT and the gate electrode GE from each other. The gate insulating layer GI may be provided with a contact hole through which the first connection electrode CNE1 is disposed.

The first interlayer insulating layer ILD1 may cover the gate electrode GE and the gate insulating layer GI. The first interlayer insulating layer ILD1 may be provided with a contact hole through which the first connection electrode CNE1 is disposed. The contact hole of the first interlayer insulating layer ILD1 may be connected to the contact hole of the gate insulating layer GI and a contact hole of the second interlayer insulating layer ILD2.

The capacitor electrode CPE may be disposed on the first interlayer insulating layer ILD1. The capacitor electrode CPE may overlap the gate electrode GE in the thickness direction (or the third direction DR3). The capacitor electrode CPE and the gate electrode GE may form a capacitance.

The second interlayer insulating layer ILD2 may cover the capacitor electrode CPE and the first interlayer insulating layer ILD1. The second interlayer insulating layer ILD2 may be provided with a contact hole through which the first connection electrode CNE1 is disposed. The contact hole of the second interlayer insulating layer ILD2 may be connected to the contact hole of the first interlayer insulating layer ILD1 and the contact hole of the gate insulating layer GI.

The first connection electrode CNE1 may be disposed on the second interlayer insulating layer ILD2. The first connection electrode CNE1 may electrically connect the drain electrode DE of the thin film transistor TFT and the second connection electrode CNE2 to each other. The first connection electrode CNE1 may be inserted into the contact holes defined or formed in the second interlayer insulating layer ILD2, the first interlayer insulating layer ILD1, and the gate insulating layer GI to be in contact with the drain electrode DE of the thin film transistor TFT.

The first passivation layer PAS1 may cover the first connection electrode CNE1 and the second interlayer insulating layer ILD2. The first passivation layer PAS1 may protect the thin film transistor TFT. The first passivation layer PAS 1 may be provided with a contact hole through which the second connection electrode CNE2 is disposed.

The second connection electrode CNE2 may be disposed on the first passivation layer PAS 1. The second connection electrodes CNE2 may electrically connect the first connection electrodes CNE1 and pixel electrodes AE1, AE2, and AE3 of the light emitting elements ED to each other. The second connection electrode CNE2 may be inserted into the contact hole defined or formed in the first passivation layer PAS 1 to be in contact with the first connection electrode CNE1.

The second passivation layer PAS2 may cover the second connection electrode CNE2 and the first passivation layer PAS 1. The second passivation layer PAS2 may be provided with contact holes through which the pixel electrodes AE1, AE2, and AE3 of the light emitting elements ED are disposed.

The light emitting element layer may be disposed on the thin film transistor layer TFTL. The light emitting element layer may include the light emitting elements ED and a plurality of bank structures BNS. The light emitting elements ED may include the pixel electrodes AE1, AE2, and AE3, light emitting layers EL1, EL2, and EL3, and common electrodes CE1, CE2, and CE3.

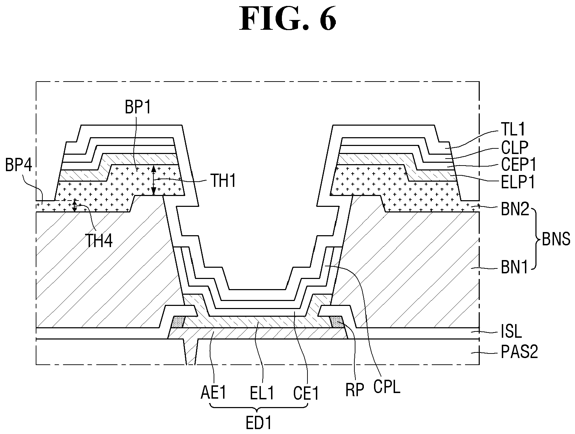

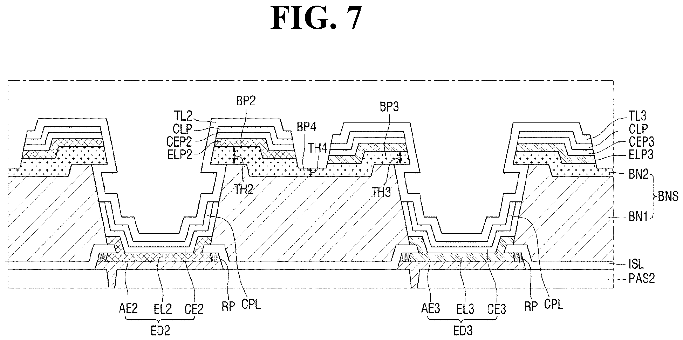

FIG. 6 is an enlarged view illustrating a first emission area of FIG. 5. FIG. 7 is an enlarged view illustrating a second emission area and a third emission area of FIG. 5.

Referring to FIGS. 6 and 7 in addition FIG. 5, in an embodiment, the display device 10 may include a plurality of emission areas EA1, EA2, and EA3 disposed in the display area DA. The emission areas EA1, EA2, and EA3 may include first emission areas EA1, second emission areas EA2, and third emission areas EA3 that emit light of different colors. The first to third emission areas EA1, EA2, and EA3 may emit red, green, or blue light, respectively, and colors of the light emitted from the respective emission areas EA1, EA2, and EA3 may be different or determined depending on types of the light emitting elements ED disposed in the light emitting element layer EML. In an embodiment, the first emission area EA1 may emit first light, which is red light, the second emission area EA2 may emit second light, which is green light, and the third emission area EA3 may emit third light, which is blue light. However, the disclosure is not limited thereto.

The first to third emission areas EA1, EA2, and EA3 may be defined, respectively, by a plurality of openings OPE1, OPE2, and OPE3 defined or formed in the bank structure BNS of the light emitting element layer EML. In an embodiment, for example, the first emission area EA1 may be defined by a first opening OPE1 of the bank structure BNS, the second emission area EA2 may be defined by a second opening OPE2 of the bank structure BNS, and the third emission area EA3 may be defined by a third opening OPE3 of the bank structure BNS.

In an embodiment, areas or sizes of the first to third emission areas EA1, EA2, and EA3 may be substantially the same as each other. In an embodiment, for example, in the display device 10, the openings OPE1, OPE2, and OPE3 of the bank structures BNS may have a same diameter as each other in a plan view (or when viewed in the thickness direction), and the first emission area EA1, the second emission area EA2, and the third emission area EA3 may have a same area as each other in the plan view. However, the present disclosure is not limited thereto. In the display device 10, areas or sizes of the first to third emission areas EA1, EA2, and EA3 may be different from each other. In an embodiment, for example, an area of the second emission area EA2 may be greater than areas of the first emission area EA1 and the third emission area EA3, and an area of the third emission area EA3 may be greater than an area of the first emission area EA1. An intensity of the light emitted from the emission areas EA1, EA2, and EA3 may change depending on the areas of the emission areas EA1, EA2, and EA3, and a color feeling of a screen displayed on the display device 10 or the electronic device 1 may be controlled by adjusting the areas of the emission area EA1, EA2, and EA3. FIG. 5 illustrates an embodiment where the areas of the emission areas EA1, EA2, and EA3 are substantially the same as each other, but the disclosure is not limited thereto. The areas of the emission areas EA1, EA2, and EA3 may be freely adjusted according to a color feeling of the screen desired by the display device 10 and the electronic device 1. In addition, the areas of the emission areas EA1, EA2, and EA3 may be related to light efficiency, a lifespan of light emitting elements ED, and the like, and may have a trade-off relationship with external light reflection. The areas of the emission areas EA1, EA2, and EA3 may be adjusted in consideration of the above factors.

In the display device 10, one first emission area EA1, one second emission area EA2, and one third emission area EA3 disposed adjacent to each other may form one pixel group. One pixel group may include the emission areas EA1, EA2, and EA3 that emit light of different colors to express a white gradation. However, the disclosure is not limited thereto, and a combination of the emission areas EA1, EA2, and EA3 constituting one pixel group may be variously modified depending on an arrangement of the emission areas EA1, EA2, and EA3, colors of the light emitted by the emission areas EA1, EA2, and EA3, and the like.

The display device 10 may include a plurality of light emitting elements ED1, ED2, and ED3 disposed in different emission areas EA1, EA2, and EA3, respectively. The light emitting elements ED1, ED2, and ED3 may include a first light emitting element ED1 disposed in the first emission area EA1, a second light emitting element ED2 disposed in the second emission area EA2, and a third light emitting element ED3 disposed in the third emission area EA3. The light emitting elements ED1, ED2, and ED3 may include pixel electrodes AE1, AE2, and AE3, light emitting layers EL1, EL2, and EL3, and common electrodes CE1, CE2, and CE3, respectively, and the light emitting elements ED1, ED2, and ED3 disposed in the different emission areas EA1, EA2, and EA3 may emit light of different colors depending on materials of the light emitting layers EL1, EL2, and EL3, respectively. In an embodiment, for example, the first light emitting element ED1 disposed in the first emission area EA1 may emit red light, which is light of a first color, the second light emitting element ED2 disposed in the second emission area EA2 may emit green light, which is light of a second color, and the third light emitting element ED3 disposed in the third emission area EA3 may emit blue light, which is light of a third color. The first to third emission areas EA1, EA2, and EA3 constituting one pixel may include the light emitting elements ED 1, ED2, and ED3 emitting the light of the different colors to express a white gradation.

The pixel electrodes AE1, AE2, and AE3 may be disposed on the second passivation layer PAS2. Each of the pixel electrodes AE1, AE2, and AE3 may be disposed to overlap a corresponding one of the openings OPE1, OPE2, and OPE3 of the bank structure BNS. The pixel electrodes AE1, AE2, and AE3 may be electrically connected to the drain electrodes DE of the thin film transistors TFT through the first and second connection electrodes CNE1 and CNE2.

The pixel electrodes AE1, AE2, and AE3 may be disposed in the plurality of emission areas EA1, EA2, and EA3, respectively. The pixel electrodes AE1, AE2, and AE3 may include a first pixel electrode AE1 disposed in the first emission area EA1, a second pixel electrode AE2 disposed in the second emission area EA2, and a third pixel electrode AE3 disposed in the third emission area EA3. The first pixel electrode AE1, the second pixel electrode AE2, and the third pixel electrode AE3 may be disposed to be spaced apart from each other on the second passivation layer PAS2, respectively. The pixel electrodes AE1, AE2, and AE3 may be disposed in the different emission areas EA1, EA2, and EA3, respectively, to constitute the light emitting elements ED1, ED2, and ED3 that emit the light of the different colors, respectively.

An inorganic insulating layer ISL may be disposed on the second passivation layer PAS2 and the pixel electrodes AE1, AE2, and AE3. The inorganic insulating layer ISL may be entirely disposed on the second passivation layer PAS2, but may expose portions of upper surfaces of the pixel electrodes AE1, AE2, and AE3 while partially overlapping the pixel electrodes AE1, AE2, and AE3. The inorganic insulating layer ISL may expose the pixel electrodes AE1, AE2, and AE3 in portions thereof overlapping the openings OPE1, OPE2, and OPE3 of the bank structure BNS, and the light emitting layers EL1, EL2, and EL3 disposed on the pixel electrodes AE1, AE2, and AE3, respectively, may be directly disposed on the pixel electrodes AE1, AE2, and AE3, respectively. The inorganic insulating layer ISL may include an inorganic insulating material. In an embodiment, for example, the inorganic insulating layer ISL may include aluminium oxide, titanium oxide, tantalum oxide, hafnium oxide, zinc oxide, silicon oxide, silicon nitride, and/or silicon oxynitride.

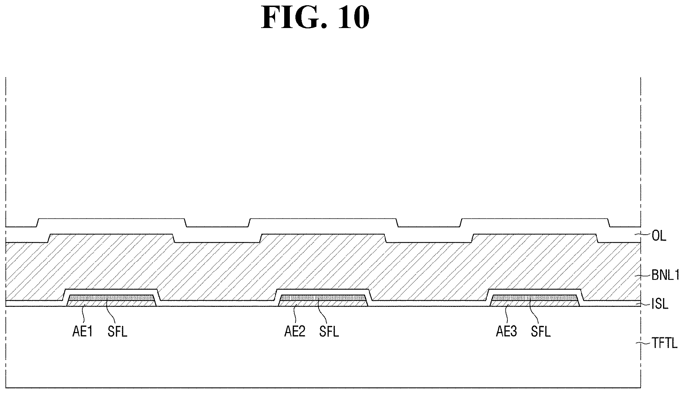

According to an embodiment, the inorganic insulating layer ISL may be disposed on the pixel electrodes AE1, AE2, and AE3, but may be spaced apart from the upper surfaces of the pixel electrodes AE1, AE2, and AE3. The inorganic insulating layer ISL may not be in direct contact with the pixel electrodes AE1, AE2, and AE3 while partially overlapping the pixel electrodes AE1, AE2, and AE3, and portions of the light emitting layers EL1, EL2, and EL3 of the light emitting elements ED1, ED2, and ED3 may be disposed between the inorganic insulating layer ISL and the pixel electrodes AE1, AE2, and AE3. In processes for fabrication of the display device 10, a sacrificial layer SFL (see FIG. 10) may be disposed on the pixel electrodes AE1, AE2, and AE3 before the inorganic insulating layer ISL is formed. The inorganic insulating layer ISL may be disposed to cover portions of the sacrificial layer, and may then be spaced apart from the upper surfaces of the pixel electrodes AE1, AE2, and AE3 while the sacrificial layer is removed. Thereafter, in a deposition process of the light emitting layers EL1, EL2, and EL3, portions of the inorganic insulating layer ISL may be disposed on the light emitting layers EL1, EL2, and EL3 while materials forming the light emitting layers EL1, EL2, and EL3 fill spaces between the inorganic insulating layer ISL and the pixel electrodes AE1, AE2, and AE3. However, the inorganic insulating layer ISL may be in direct contact with side surfaces of the pixel electrodes AE1, AE2, and AE3.

The display device 10 may include the plurality of bank structures BNS disposed on the thin film transistor layer TFTL or the substrate SUB and provided with the plurality of openings OPE1, OPE2, and OPE3. The bank structure BNS may have a structure in which bank layers BN1 and BN2 including different materials are sequentially stacked, and may be provided with the plurality of openings OPE1, OPE2, and OPE3 defining or forming the emission areas EA1, EA2, and EA3. The light emitting elements ED1, ED2, and ED3 of the display device 10 may be disposed to overlap the openings OPE1, OPE2, and OPE3 of the bank structure BNS.

The bank structure BNS may include a first bank layer BN1 disposed on the inorganic insulating layer ISL and a second bank layer BN2 disposed on the first bank layer BN1.

According to an embodiment, the first bank layer BN1 and the second bank layer BN2 include different materials from each other, and the second bank layer BN2 of the bank structure BNS includes tips TIP protruding from the first bank layer BN1 toward the openings OPE1, OPE2, and OPE3. In the bank structure BNS, sides of the first bank layer BN1 may have a shape in which they are recessed inward from sides of the second bank layer BN2. The second bank layer BN2 has a shape in which it protrudes more (or further) than the first bank layer BN1 toward the openings OPE1, OPE2, and OPE3, and accordingly, inner sidewalls defining the openings OPE1, OPE2, and OPE3 of the bank structure BNS may have undercuts formed under the tips TIP of the second bank layer BN2.

A sidewall shape of the bank structure BNS may be a structure formed due to a difference between etch rates of the first bank layer BN1 and the second bank layer BN2 in an etching process because the first bank layer BN1 and the second bank layer BN2 include different materials from each other. According to an embodiment, the second bank layer BN2 may include a material different from that of the first bank layer BN1 in an etch rate or an etchant for etching, and the first bank layer BN1 may be further etched in a process of forming the openings OPE1, OPE2, and OPE3 of the bank structure BNS, such that the undercuts may be formed under the tips TIP of the second bank layer BN2.

In an embodiment, the first bank layer BN1 may include a metal material having a high electrical conductivity, and the second bank layer BN2 may include an organic insulating material. In an embodiment, for example, the first bank layer BN1 may include or be made of an AlNiLaCu alloy including aluminium (Al), nickel (Ni), lanthanum (La), and copper (Cu), and the second bank layer BN2 may include polyimide. The bank structure BNS may have a structure in which AlNiLaCu and an organic film are stacked on the inorganic insulating layer ISL, and the tips TIP may be formed in the organic film of the second bank layer BN2.

The bank structure BNS may be provided with the openings OPE1, OPE2, and OPE3 defining or forming the emission areas EA1, EA2, and EA3, and may be disposed to overlap a light blocking layer BM to be described later. The uppermost layer of the bank structure BNS may include a material having a low reflectivity to reduce external light reflection. In addition, in the bank structure BNS, the first bank layer BN1 may be electrically connected to the common electrodes CE1, CE2, and CE3 of different light emitting elements ED1, ED2, and ED3. The common electrodes CE1, CE2, and CE3 of the light emitting elements ED1, ED2, and ED3 disposed in the different emission areas EA1, EA2, and EA3 are not directly connected to each other, but may be electrically connected to each other through the first bank layer BN1 of the bank structure BNS.

In a conventional process for fabrication of the display device 10, a mask process may be used to form the light emitting layers EL1, EL2, and EL3 of the light emitting elements ED1, ED2, and ED3 for each of the emission areas EA1, EA2, and EA3. The display device 10 may include a structure for mounting a mask to perform the mask process, or be provided with an undesirably great area of the non-display area NDA to control dispersion according to the mask process. If such a mask process is minimized, an undesired component such as the structure for mounting the mask may be omitted from the display device 10, and the area of the non-display area NDA for controlling the dispersion may be minimized.

The display device 10 according to an embodiment includes the bank structure BNS forming the emission areas EA1, EA2, and EA3, and thus, the light emitting elements ED1, ED2, and ED3 may be formed by deposition and etching processes instead of the mask process. In such an embodiment, the bank structure BNS includes the first bank layer BN1 and the second bank layer BN2 including the different materials from each other to have a structure in which the tips TIP are formed on the inner sidewalls of the openings OPE1, OPE2, and OPE3, and accordingly, it is possible to individually form different layers in the different emission areas EA1, EA2, and EA3 even through the deposition process. In an embodiment, for example, even though the light emitting layers EL1, EL2, and EL3 and the common electrodes CE1, CE2, and CE3 of the light emitting elements ED1, ED2, and ED3 are formed by a deposition process that does not use the mask, deposited materials may be disconnected from each other, rather than being connected to each other between the openings OPE1, OPE2, and OPE3, by the tips TIP of the second bank layer BN2 formed on the inner sidewalls defining the openings OPE1, OPE2, and OPE3. It is possible to form individually the different layers in the different emission areas EA1, EA2, and EA3 through a process of forming a material for forming a specific layer on the entire surface of the display device 10 and then etching and removing a layer formed in unwanted areas. In the display device 10, through the deposition and etching processes without using the mask process, the different light emitting elements ED1, ED2, and ED3 may be formed for each of the emission areas EA1, EA2, and EA3, the unnecessary component may be omitted from the display device 10, and the area of the non-display area NDA may be minimized.

The display device 10 may include patterns that are traces according to a shape and a deposition process of the bank structure BNS. These patterns may be formed simultaneously with the light emitting layers EL1, EL2, and EL3 and the common electrodes CE1, CE2, and CE3 of the light emitting elements ED 1, ED2, and ED3, and may remain on the bank structure BNS.

The light emitting layers EL1, EL2, and EL3 may be disposed on the pixel electrodes AE1, AE2, and AE3. The light emitting layers EL1, EL2, and EL3 may be organic light emitting layers including or made of an organic material, and may be formed on the pixel electrodes AE1, AE2, and AE3 through a deposition process. When the thin film transistors TFT apply a predetermined voltage to the pixel electrodes AE1, AE2, and AE3 of the light emitting elements ED1, ED2, and ED3 and the common electrodes CE1, CE2, and CE3 of the light emitting elements ED 1, ED2, and ED3 receives a common voltage or a cathode voltage, holes and electrons may move to the light emitting layers EL1, EL2, and EL3 through hole transporting layers and electron transporting layers, respectively, and may be combined with each other in the light emitting layers EL1, EL2, and EL3 to emit light.

The light emitting layers EL1, EL2, and EL3 may include a first light emitting layer EL1, a second light emitting layer EL2, and a third light emitting layer EL3 disposed in the different emission areas EA1, EA2, and EA3, respectively. The first light emitting layer EL1 may be disposed on the first pixel electrode AE1 in the first emission area EA1, the second light emitting layer EL2 may be disposed on the second pixel electrode AE2 in the second emission area EA2, and the third light emitting layer EL3 may be disposed on the third pixel electrode AE3 in the third emission area EA3. The first to third light emitting layers EL1, EL2, and EL3 may be light emitting layers of the first to third light emitting elements ED1, ED2 and ED3, respectively. The first light emitting layer EL1 may be a light emitting layer emitting the red light, which is the light of the first color, the second light emitting layer EL2 may be a light emitting layer emitting the green light, which is the light of the second color, and the third light emitting layer EL3 may be a light emitting layer emitting the blue light, which is the light of the third color.

According to an embodiment, portions of the light emitting layers EL1, EL2, and EL3 of the light emitting elements ED1, ED2, and ED3 may be disposed between the pixel electrodes AE1, AE2, and AE3 and the inorganic insulating layer ISL. The inorganic insulating layer ISL may be disposed on the pixel electrodes AE1, AE2, and AE3, but may be spaced apart from the upper surfaces of the pixel electrodes AE1, AE2, and AE3. The deposition process of the light emitting layers EL1, EL2, and EL3 may be performed so that materials of the light emitting layers are deposited in a direction inclined with respect to an upper surface of the substrate SUB rather than a direction perpendicular to the upper surface of the substrate SUB. Accordingly, the light emitting layers EL1, EL2, and EL3 may be disposed on the upper surfaces of the pixel electrodes AE1, AE2, and AE3 exposed in the openings OPE1, OPE2, and OPE3 of the bank structure BNS, and may be disposed to fill spaces between the pixel electrodes AE1, AE2, and AE3 and the inorganic insulating layer ISL.

In the processes for fabrication of the display device 10, a sacrificial layer SFL (see FIG. 10) may be disposed between the inorganic insulating layer ISL and the pixel electrodes AE1, AE2, and AE3, and the light emitting layers EL1, EL2, and EL3 may then be disposed in areas in which the sacrificial layer SFL is partially removed. Accordingly, a lower surface of the inorganic insulating layer ISL may be spaced apart from the pixel electrodes AE1, AE2, and AE3. However, the sacrificial layer SFL may remain as partial residual patterns RP in areas between the inorganic insulating layer ISL and the pixel electrodes AE1, AE2, and AE3. The areas between the inorganic insulating layer ISL and the pixel electrodes AE1, AE2, and AE3 may be filled with the partial residual patterns RP and the light emitting layers EL1, EL2, and EL3.

The display device 10 according to an embodiment may include a plurality of organic patterns ELP1, ELP2, and ELP3 including a same materials as the light emitting layers EL1, EL2, and EL3, respectively, and disposed on the bank structure BNS. Since the light emitting layers EL1, EL2, and EL3 are formed through a process of depositing materials on the entire surface of the display device 10, the materials forming the light emitting layers EL1, EL2, and EL3 may be deposited on the bank structure BNS as well as in the openings OPE1, OPE2, and OPE3 of the bank structure BNS.

In an embodiment, for example, the display device 10 may include the organic patterns ELP1, ELP2, and ELP3 disposed on the bank structure BNS. The organic patterns ELP1, ELP2, and ELP3 may include a first organic pattern ELP1, a second organic pattern ELP2, and a third organic pattern ELP3 disposed on the second bank layer BN2 of the bank structure BNS.

The first organic pattern ELP1 may include a same material as the first light emitting layer EL1 of the first light emitting element ED1. The second organic pattern ELP2 may include a same material as the second light emitting layer EL2 of the second light emitting element ED2, and the third organic pattern ELP3 may include a same material as the third light emitting layer EL3 of the third light emitting element ED3. The organic patterns ELP1, ELP2, and ELP3 may be formed in a same processes as the light emitting layers EL1, EL2, and EL3 including the same materials as the organic patterns ELP1, ELP2, and ELP3, respectively.

The first organic pattern ELP1, the second organic pattern ELP2, and the third organic pattern ELP3 may be directly disposed on the second bank layer BN2 of the bank structure BNS. The organic patterns ELP1, ELP2, and ELP3 may be formed in the same processes as the light emitting layers EL1, EL2, and EL3 including the same materials as the organic patterns ELP1, ELP2, and ELP3, respectively, and may be disposed adjacent to the emission areas EA1, EA2, and EA3 in which the respective light emitting layers EL1, EL2, and EL3 are disposed. In an embodiment, for example, the first organic pattern ELP1 may be disposed on the second bank layer BN2 while surrounding the first opening OPE1 around the first emission area EA1 or the first opening OPE1. The second organic pattern ELP2 may be disposed on the second bank layer BN2 while surrounding the second opening OPE2 around the second emission area EA2 or the second opening OPE2, and the third organic pattern ELP3 may be disposed on the second bank layer BN2 while surrounding the third opening OPE3 around the third emission area EA3 or the third opening OPE3.

Such organic patterns ELP1, ELP2, and ELP3 may be traces formed while the deposited materials are disconnected from the light emitting layers EL1, EL2, and EL3 rather than being connected to the light emitting layers EL1, EL2, and EL3 because the bank structure BNS includes the tips TIP. The light emitting layers EL1, EL2, and EL3 may be formed in the openings OPE1, OPE2, and OPE3, and the organic patterns ELP1, ELP2, and ELP3 and the light emitting layers EL1, EL2, and EL3 may be disconnected from each other by the tips TIP formed on the sidewalls defining the openings OPE1, OPE2, and OPE3. The light emitting layers EL1, EL2, and EL3 are formed through the deposition process that does not use a mask, and accordingly, materials of the light emitting layers EL1, EL2, and EL3 may be entirely formed on the bank structure BNS, and the organic patterns ELP1, ELP2, and ELP3 may be formed by patterning these materials around the emission areas EA1, EA2, and EA3 or the openings OPE1, OPE2, and OPE3.

The common electrodes CE1, CE2, and CE3 may be disposed on the light emitting layers EL1, EL2, and EL3. The common electrodes CE1, CE2, and CE3 may include a transparent conductive material to emit light generated from the light emitting layers EL1, EL2, and EL3. The common electrodes CE1, CE2, and CE3 may receive a common voltage or a low potential voltage. When the pixel electrodes AE1, AE2, and AE3 receive a voltage corresponding to a data voltage and the common electrodes CE1, CE2, and CE3 receive the low potential voltage, potential differences are formed between the pixel electrodes AE1, AE2, and AE3 and the common electrodes CE1, CE2, and CE3, such that the light emitting layers EL1, EL2, and EL3 may emit light.

The common electrodes CE1, CE2, and CE3 may include a first common electrode CE1, a second common electrode CE2, and a third common electrode CE3 disposed in the different emission areas EA1, EA2, and EA3. The first common electrode CE1 may be disposed on the first light emitting layer EL1 in the first emission area EA1, the second common electrode CE2 may be disposed on the second light emitting layer EL2 in the second emission area EA2, and the third common electrode CE3 may be disposed on the third light emitting layer EL3 in the third emission area EA3.

According to an embodiment, portions of the common electrodes CE1, CE2, and CE3 of the light emitting elements ED1, ED2, and ED3 may be disposed on side surfaces of the first bank layer BN1 of the bank structure BNS. Similar to the light emitting layers EL1, EL2, and EL3, the common electrodes CE1, CE2, and CE3 may also be formed through a deposition process. The deposition process of the common electrodes CE1, CE2, and CE3 may be performed so that electrode materials are deposited in a direction inclined with respect to the upper surface of the substrate SUB rather than the direction perpendicular to the upper surface of the substrate SUB. Accordingly, the common electrodes CE1, CE2, and CE3 may be disposed on the side surfaces of the first bank layer BN1 under the tips TIP of the second bank layer BN2 of the bank structure BNS. The common electrodes CE1, CE2, and CE3 may be in direct contact with the side surfaces of the first bank layer BN1. The common electrodes CE1, CE2, and CE3 of the different light emitting elements ED1, ED2, and ED3 may be in direct contact with the first bank layer BN1 of the bank structure BNS, respectively, and the common electrodes CE1, CE2, and CE3 may be electrically connected to each other. Unlike the pixel electrodes AE1, AE2, and AE3, the common electrodes CE1, CE2, and CE3 are not divided for each of the plurality of pixels, and may be implemented in an electrode form that is electrically common to all pixels.

According to an embodiment, a contact area between the common electrodes CE1, CE2, and CE3 and the side surfaces of the first bank layer BN1 may be greater than a contact area between the light emitting layers EL1, EL2, and EL3 and the side surfaces of the first bank layer BN1. Each of the deposition processes of the common electrodes CE1, CE2, and CE3 and the light emitting layers EL1, EL2, and EL3 may be performed so that the materials of the common electrodes CE1, CE2, and CE3 and the light emitting layers EL1, EL2, and EL3 are deposited in the direction inclined with respect to the upper surface of the substrate SUB rather than the direction perpendicular to the upper surface of the substrate SUB, and areas of the common electrodes CE1, CE2, and CE3 and the light emitting layers EL1, EL2, and EL3 disposed on the side surfaces of the first bank layer BN1 may change depending on an inclined angle. In an embodiment, the deposition process of the common electrodes CE1, CE2, and CE3 may be performed in a more inclined direction than the deposition process of the light emitting layers EL1, EL2, and EL3. The common electrodes CE1, CE2, and CE3 may be disposed to have a greater area than the light emitting layers EL1, EL2, and EL3 on the sidewalls defining the openings OPE1, OPE2, and OPE3 or may be disposed up to a greater height on the sidewalls defining the openings OPE1, OPE2, and OPE3 than the light emitting layers EL1, EL2, and EL3. Since the common electrodes CE1, CE2, and CE3 of the different light emitting elements ED1, ED2, and ED3 are electrically connected to each other through the first bank layer BN1, it may be desired that the common electrodes CE1, CE2, and CE3 are in contact with the first bank layer BN1 in a greater area.

In addition, since the bank structure BNS includes the second bank layer BN2 including or made of the organic insulating material, the tips TIP of the second bank layer BN2 may be desired to have a sufficient thickness regardless of a type of the openings OPE1, OPE2, and OPE3. The tips TIP of the second bank layer BN2 are maintained in a shape in which they protrude without sagging, and accordingly, areas of the common electrodes CE1, CE2, and CE3 of the different light emitting elements ED1, ED2, and ED3 in contact with the side surfaces of first bank layer BN1 may be uniform.

The display device 10 according to an embodiment may include a plurality of electrode patterns CEP1, CEP2, and CEP3 including the same materials as the common electrodes CE1, CE2, and CE3 and disposed on the bank structure BNS. Since the common electrodes CE1, CE2, and CE3 are formed through a process of depositing materials on the entire surface of the display device 10, materials forming the common electrodes CE1, CE2, and CE3 may be deposited on the bank structure BNS as well as in the openings OPE1, OPE2, and OPE3 of the bank structure BNS.

The display device 10 may include electrode patterns CEP1, CEP2, and CEP3 disposed on the bank structure BNS. The electrode patterns CEP1, CEP2, and CEP3 may include a first electrode pattern CEP1, a second electrode pattern CEP2, and a third electrode pattern CEP3 disposed on the second bank layer BN2 of the bank structure BNS.

In an embodiment, for example, the first electrode pattern CEP1, the second electrode pattern CEP2, and the third electrode pattern CEP3 may be directly disposed on the first organic pattern ELP1, the second organic pattern ELP2, and the third organic pattern ELP3, respectively. An arrangement relationship between the electrode patterns CEP1, CEP2, and CEP3 and the organic patterns ELP1, ELP2, and ELP3 may be substantially the same as an arrangement relationship between the light emitting layers EL1, EL2, and EL3 and the common electrodes CE1, CE2, and CE3 of the light emitting elements ED1, ED2, and ED3. Such electrode patterns CEP1, CEP2, and CEP3 may be traces formed while the deposited materials are disconnected from the common electrodes CE1, CE2, and CE3 rather than being connected to the common electrodes CE1, CE2, and CE3 because the bank structure BNS includes the tips TIP. In the display device 10, the common electrodes CE1, CE2, and CE3 may be individually formed in different areas even in the deposition process that does not use the mask by the tips TIP of the bank structure BNS.

Capping layers CPL may be disposed on the common electrodes CE1, CE2, and CE3. The capping layers CPL may include an inorganic insulating material and cover the light emitting elements ED1, ED2, and ED3 and the patterns disposed on the bank structure BNS. The capping layers CPL may prevent damage to the light emitting elements ED1, ED2, and ED3 from external air, and prevent the patterns disposed on the bank structure BNS from being peeled off during the processes for fabrication of the display device 10. In an embodiment, the capping layer CPL may include aluminium oxide, titanium oxide, tantalum oxide, hafnium oxide, zinc oxide, silicon oxide, silicon nitride, and/or silicon oxynitride.

The display device 10 may include capping patterns CLP disposed above the bank structure BNS. The capping patterns CLP may be directly disposed on the first electrode pattern CEP1, the second electrode pattern CEP2, and the third electrode pattern CEP3 disposed on the second bank layer BN2 of the bank structure BNS. An arrangement relationship between the capping patterns CLP and the electrode patterns CEP1, CEP2, and CEP3 may be substantially the same as an arrangement relationship between the common electrodes CE1, CE2, and CE3 of the light emitting elements ED1, ED2, and ED3 and the capping layers CPL. Such capping patterns CLP may be traces formed while the deposited materials are disconnected from the capping layers CPL rather than being connected to the capping layers CPL because the bank structure BNS includes the tips TIP.

The plurality of organic patterns ELP1, ELP2, and ELP3, the electrode patterns CEP1, CEP2, and CEP3, and the capping patterns CLP may be disposed on the bank structure BNS, and may be disposed to surround the emission areas EA1, EA2, and EA3 or the openings OPE1, OPE2, and OPE3. A stacked structure of the organic patterns ELP1, ELP2, and ELP3, the electrode patterns CEP1, CEP2, and CEP3, and the capping patterns CLP disposed around the emission areas EA1, EA2, and EA3 may be partially etched in the processes for fabrication of the display device 10, such that a pattern shape may be changed. Accordingly, portions of an upper surface of the second bank layer BN2 of the bank structure BNS may not be covered by the organic patterns ELP1, ELP2, and ELP3, the electrode patterns CEP1, CEP2, and CEP3, and the capping patterns CLP.

The thin film encapsulation layer TFEL may be disposed on the light emitting elements ED1, ED2, and ED3 and the bank structure BNS, and may cover the plurality of light emitting elements ED1, ED2, and ED3 and the bank structure BNS. The thin film encapsulation layer TFEL may include at least one inorganic film to prevent oxygen or moisture from permeating into the light emitting element layer EML. The thin film encapsulation layer TFEL may include at least one organic film to protect the light emitting element layer EML from foreign materials such as dust.

In an embodiment, the thin film encapsulation layer TFEL may include a first encapsulation layer TFE1, a second encapsulation layer TFE2, and a third encapsulation layer TFE3 that are sequentially stacked. The first encapsulation layer TFE1 and the third encapsulation layer TFE3 may be inorganic encapsulation layers, and the second encapsulation layer TFE2 disposed between the first encapsulation layer TFE1 and the third encapsulation layer TFE3 may be an organic encapsulation layer.

Each of the first encapsulation layer TFE1 and the third encapsulation layer TFE3 may include one or more inorganic insulating materials. The inorganic insulating material may include aluminium oxide, titanium oxide, tantalum oxide, hafnium oxide, zinc oxide, silicon oxide, silicon nitride, and/or silicon oxynitride.

The second encapsulation layer TFE2 may include a polymer-based material. The polymer-based material may include at least one selected from an acrylic resin, an epoxy-based resin, polyimide, polyethylene, and the like. In an embodiment, for example, the second encapsulation layer TFE2 may include an acrylic resin such as polymethyl methacrylate or polyacrylic acid. The second encapsulation layer TFE2 may be formed by curing a monomer or applying a polymer.

The first encapsulation layer TFE1 may be disposed on the light emitting elements ED1, ED2, and ED3, a plurality of patterns, and the bank structure BNS. The first encapsulation layer TFE1 may include a first inorganic layer TL1, a second inorganic layer TL2, and a third inorganic layer TL3 disposed to correspond respectively to the different emission areas EA1, EA2, and EA3.

The first inorganic layer TL1, the second inorganic layer TL2, and the third inorganic layer TL3 may include an inorganic insulating material and cover the light emitting elements ED1, ED2, and ED3, respectively. The first inorganic layer TL1, the second inorganic layer TL2, and the third inorganic layer TL3 may prevent damage to the light emitting elements ED1, ED2, and ED3 from external air and prevent the patterns disposed on the bank structure BNS from being peeled off during the processes for fabrication of the display device 10. In an embodiment, the first inorganic layer TL1, the second inorganic layer TL2, and the third inorganic layer TL3 may include aluminium oxide, titanium oxide, tantalum oxide, hafnium oxide, zinc oxide, silicon oxide, silicon nitride, and/or silicon oxynitride.

The first inorganic layer TL1, the second inorganic layer TL2, and the third inorganic layer TL3 may be disposed to cover the organic patterns ELP1, ELP2, and ELP3, the electrode patterns CEP1, CEP2, and CEP3, and the capping patterns CLP. The first inorganic layer TL1, the second inorganic layer TL2, and the third inorganic layer TL3 may be formed through chemical vapor deposition (CVD), and may thus be formed at a uniform thickness along steps of layers on which they are deposited. In an embodiment, for example, the first inorganic layer TL1, the second inorganic layer TL2, and the third inorganic layer TL3 may form thin films even under the undercuts by the tips TIP of the bank structure BNS.

The first inorganic layer TL1 may be disposed on the first light emitting element ED1 and the first electrode pattern CEP1. The first inorganic layer TL1 may be disposed along the first light emitting element ED 1 and the inner sidewall defining the first opening OPE1 to cover the first light emitting element ED1 and the inner sidewall defining the first opening OPE1, and may also be disposed to cover the first organic pattern ELP1, the first electrode pattern CEP1, and the capping pattern CLP. However, the first inorganic layer TL1 may not overlap the second opening OPE2 and the third opening OPE3, and may be disposed only in the first opening OPE1 and on the bank structure BNS around the first opening OPE1.

The second inorganic layer TL2 may be disposed on the second light emitting element ED2 and the second electrode pattern CEP2. The second inorganic layer TL2 may be disposed along the second light emitting element ED2 and the inner sidewall defining the second opening OPE2 to cover the second light emitting element ED2 and the inner sidewall defining the second opening OPE2, and may also be disposed to cover the second organic pattern ELP2, the second electrode pattern CEP2, and the capping pattern CLP. However, the second inorganic layer TL2 may not overlap the first opening OPE1 and the third opening OPE3, and may be disposed only in the second opening OPE2 and on the bank structure BNS around the second opening OPE2.

The third inorganic layer TL3 may be disposed on the third light emitting element ED3 and the third electrode pattern CEP3. The third inorganic layer TL3 may be disposed along the third light emitting element ED3 and the inner sidewall defining the third opening OPE3 to cover the third light emitting element ED3 and the inner sidewall defining the third opening OPE3, and may also be disposed to cover the third organic pattern ELP3, the third electrode pattern CEP3, and the capping pattern CLP. However, the third inorganic layer TL3 may not overlap the first opening OPE1 and the second opening OPE2, and may be disposed only in the third opening OPE3 and on the bank structure BNS around the third opening OPE3.

The first inorganic layer TL1 may be formed after the first common electrode CE1 is formed, the second inorganic layer TL2 may be formed after the second common electrode CE2 is formed, and the third inorganic layer TL3 may be formed after the third common electrode CE3 is formed. Accordingly, the first to third inorganic layers TL1, TL2, and TL3 may be disposed to cover different electrode patterns CEP1, CEP2, and CEP3 and organic patterns ELP1, ELP2, and ELP3, respectively. Each of the first inorganic layer TL1, the second inorganic layer TL2, and the third inorganic layer TL3 may have a greater area than each of the openings OPE1, OPE2, and OPE3 of the bank structure BNS in a plan view. The first inorganic layer TL1, the second inorganic layer TL2, and the third inorganic layer TL3 may be disposed to be spaced apart from each other on the bank structure BNS. Accordingly, portions of the second bank layer BN2 of the bank structure BNS may not overlap the inorganic layers TL1, TL2, and TL3, and portions of the upper surface of the second bank layer BN2 of the bank structure BNS may be exposed without being covered by the inorganic layers TL1, TL2, and TL3. Portions of the second bank layer BN2 may be in direct contact with a second encapsulation layer TFE2 of a thin film encapsulation layer TFEL to be described later.

In an embodiment, as described above, after the first to third inorganic layers TL1, TL2, and TL3 are entirely formed on the bank structure BNS, the first to third inorganic layers TL1, TL2, and TL3 may be disposed to cover only the light emitting elements ED1, ED2, and ED3 in the respective emission areas EA1, EA2, and EA3, the organic patterns ELP1, ELP2, and ELP3, and the electrode patterns CEP1, CEP2, and CEP3, but may not be disposed between the emission areas EA1, EA2, and EA3. The inorganic layers TL1, TL2, and TL3 may be formed in such a shape by forming the inorganic layers TL1, TL2, and TL3 to completely cover the bank structure BNS and then partially patterning the inorganic layers TL1, TL2, and TL3. The inorganic layers TL1, TL2, and TL3 may include an inorganic insulating material, and an etchant capable of etching the inorganic insulating material may be used for patterning processes of the inorganic layers TL1, TL2, and TL3. If the second bank layer BN2 of the bank structure BNS is exposed in the patterning processes, the second bank layer BN2 may be partially removed or damaged by a specific etchant.

In particular, the first inorganic layer TL1, the second inorganic layer TL2, and the third inorganic layer TL3 may be patterned in individual processes, respectively, and the patterning processes of the inorganic layers TL1, TL2, and TL3 may be repeated several times. The second bank layer BN2 is exposed for each of the repeated patterning processes, so that a thickness of the second bank layer BN2 may be decreased and the tips TIP of the second bank layer BN2 in the bank structure BNS may be thinned. In an embodiment, for example, when processes of forming the first light emitting element ED1, the second light emitting element ED2, and the third light emitting element ED3 are sequentially performed, the second bank layer BN2 around the third opening OPE3 may be in the most vulnerable state.

In this case, the tips TIP corresponding to some of the openings OPE1, OPE2, and OPE3, for example, the third opening OPE3 may sag without being maintained in a shape in which they protrude from sidewalls of the first bank layer BN1, and when the tips TIP sag, the contact between the common electrodes CE1, CE2, and CE3 of the light emitting elements ED1, ED2, and ED3 and the side surfaces of the first bank layer BN1 may not be smooth. Accordingly, contact resistances between the common electrodes CE1, CE2, and CE3 and the first bank layer BN1 may increase, which may cause a decrease in luminance of some of the light emitting elements ED1, ED2, and ED3 to cause a mura in the display device 10.

In the display device 10 according to an embodiment, the second bank layer BN2 of the bank structure BNS may have a thickness and a material enough to prevent the tips TIP of the second bank layer BN2 from sagging even though the second bank layer BN2 is partially damaged in the processes for fabrication of the display device 10. In an embodiment, for example, the second bank layer BN2 may include the organic insulating material to have a great thickness, similar to the first bank layer BN1. Since the second bank layer BN2 has a sufficiently great thickness as compared with a metal material having a low reflectivity, the second bank layer BN2 may have a thickness enough (or greater than a predetermined thickness) to prevent the tips TIP of the second bank layer BN2 from sagging even though a portion of the second bank layer BN2 is etched in etching processes of forming the inorganic layers TL1, TL2, and TL3.

In an embodiment, as described above, the organic patterns ELP1, ELP2, and ELP3, the electrode patterns CEP1, CEP2, and CEP3, and the inorganic layers TL1, TL2, and TL3 may be formed by entirely forming these patterns on the second bank layer BN2 and then performing patterning processes of removing portions of these patterns, respectively. In the patterning processes, portions of the second bank layer BN2 may be removed together with the inorganic layers TL1, TL2, and TL3 removed while the upper surface of the second bank layer BN2 is exposed. Accordingly, thicknesses of the second bank layer BN2 in an area that is exposed and an area that is not exposed in the patterning processes may be different from each other.

According to an embodiment, thicknesses TH1, TH2, and TH3 of portions BP1, BP2 and BP3 of the second bank layer BN2 that overlap the organic patterns ELP1, ELP2, and ELP3, the electrode patterns CEP1, CEP2, and CEP3, and the inorganic layers TL1, TL2, and TL3 may be greater than a thickness TH4 of portions BP4 of the second bank layer BN2 that do not overlap the organic patterns ELP1, ELP2, and ELP3, the electrode patterns CEP1, CEP2, and CEP3, and the inorganic layers TL1, TL2, and TL3. The second bank layer BN2 may be divided into a first bank part BP1, a second bank part BP2, a third bank part BP3, and fourth bank parts BP4 according to positions. The first bank part BP1, the second bank part BP2, and the third bank part BP3 may be portions that overlap the organic patterns ELP1, ELP2, and ELP3, the electrode patterns CEP1, CEP2, and CEP3, and the inorganic layers TL1, TL2, and TL3, and the fourth bank parts BP4 may be portions that do not overlap the organic patterns ELP1, ELP2, and ELP3, the electrode patterns CEP1, CEP2, and CEP3, and the inorganic layers TL1, TL2, and TL3.

The first bank part BP1 may be a portion of the second bank layer BN2 that overlaps the first organic pattern ELP1, the first electrode pattern CEP1, and the first inorganic layer TL1. The first bank part BP1 may be disposed around the first opening OPE1 or the first emission area EA1, and may surround the first opening OPE1 or the first emission area EA1 in a plan view, similar to the first organic pattern ELP1 and the first electrode pattern CEP1. The first bank part BP1 may be an area that is disposed below the first organic pattern ELP1 and the first electrode pattern CEP1 and thus, is not etched in a process of patterning the first inorganic layer TL1 so that the first inorganic layer TL1 covers only the first light emitting element ED1 and the periphery of the first emission area EA1. The first organic pattern ELP1 may be disposed on the first bank part BP1 of the second bank layer BN2.

The second bank part BP2 may be a portion of the second bank layer BN2 that overlaps the second organic pattern ELP2, the second electrode pattern CEP2, and the second inorganic layer TL2. The second bank part BP2 may be disposed around the second opening OPE2 or the second emission area EA2, and may surround the second opening OPE2 or the second emission area EA2 in a plan view, similar to the second organic pattern ELP2 and the second electrode pattern CEP2. The second bank part BP2 may be an area that is disposed below the second organic pattern ELP2 and the second electrode pattern CEP2 and thus, is not etched in a process of patterning the second inorganic layer TL2 so that the second inorganic layer TL2 covers only the second light emitting element ED2 and the periphery of the second emission area EA2. The second organic pattern ELP2 may be disposed on the second bank part BP2 of the second bank layer BN2. However, a patterning process of forming the first inorganic layer TL1 is performed before the second organic pattern ELP2 and the second electrode pattern CEP2 are formed, and thus, the second bank part BP2 may be a portion of the second bank layer BN2 partially etched in the patterning process of forming the first inorganic layer TL1.

The third bank part BP3 may be a portion of the second bank layer BN2 that overlaps the third organic pattern ELP3, the third electrode pattern CEP3, and the third inorganic layer TL3. The third bank part BP3 may be disposed around the third opening OPE3 or the third emission area EA3, and may surround the third opening OPE3 or the third emission area EA3 in a plan view, similar to the third organic pattern ELP3 and the third electrode pattern CEP3. The third bank part BP3 may be an area that is disposed below the third organic pattern ELP3 and the third electrode pattern CEP3 and thus, is not etched in a process of patterning the third inorganic layer TL3 so that the third inorganic layer TL3 covers only the third light emitting element ED3 and the periphery of the third emission area EA3. The third organic pattern ELP3 may be disposed on the third bank part BP3 of the second bank layer BN2. However, the patterning process of forming the first inorganic layer TL1 and a patterning process of forming the second inorganic layer TL2 are performed before the third organic pattern ELP3 and the third electrode pattern CEP3 are formed, and thus, the third bank part BP3 may be a portion of the second bank layer BN2 partially etched in the patterning process of forming the first inorganic layer TL1 and the patterning process of forming the second inorganic layer TL2.

According to an embodiment, in the second bank layer BN2, the thickness TH1 of the first bank part BP1 may be greater than the thickness TH2 of the second bank part BP2 and the thickness TH3 of the third bank part BP3, and the thickness TH2 of the second bank part BP2 may be greater than the thickness TH3 of the third bank part BP3. The second bank layer BN2 is partially etched in the processes for fabrication of the display device 10, and may accordingly have a shape in which thicknesses thereof are different from each other depending on positions. The first to third bank parts BP1, BP2, and BP3 may be portions disposed to surround the openings OPE1, OPE2, and OPE3 and forming the tips TIP, and thicknesses of the tips TIP may be different from each other for each of the openings OPE1, OPE2, and OPE3 of the bank structure BNS. In each of the openings OPE1, OPE2, and OPE3 of the bank structure BNS, the tip TIP formed in (or corresponding to) the first opening OPE1 may be thicker than the tips TIP formed in (or corresponding to) the second opening OPE2 and the third opening OPE3, and the tip TIP formed in (or corresponding to) the second opening OPE2 may be thicker than the tip TIP formed in (or corresponding to) the third opening OPE3.

The first bank part BP1 may be a portion covered by the first organic pattern ELP1 and the first electrode pattern CEP1 before the processes of the inorganic layers TL1, TL2, and TL3, and may be the thickest portion of the second bank layer BN2. The first bank part BP1 may be a portion disposed around the first emission area EA1 or the first opening OPE1 in which the first light emitting element ED1 formed first among the light emitting elements ED1, ED2, and ED3 is disposed.

In an embodiment in which the second light emitting element ED2 and the third light emitting element ED3 are formed after the first light emitting element ED1, the second bank part BP2 may be a portion covered by the second organic pattern ELP2 and the second electrode pattern CEP2 after the process of forming the first inorganic layer TL1 and before the process of forming the second inorganic layer TL2. The second bank part BP2 may have the thickness TH2 less than the thickness TH1 of the first bank part BP1, but may be the thickest portion among the other portions of the second bank layer BN2. The third bank part BP3 may be a portion covered by the third organic pattern ELP3 and the third electrode pattern CEP3 after the processes of forming the first inorganic layer TL1 and the second inorganic layer TL2 and before the process of forming the third inorganic layer TL3. The third bank part BP3 may have the thickness TH3 less than the thicknesses TH1 and TH2 of the first bank part BP1 and the second bank part BP2, but may be thicker than the fourth bank parts BP4.

The inorganic layers TL1, TL2, and TL3 are formed to be spaced apart from each other by the patterning processes, and accordingly, the second bank layer BN2 may include portions in direct contact with the second encapsulation layer TFE2 on the upper surface thereof without overlapping the inorganic layers TL1, TL2, and TL3. The fourth bank parts BP4 may be portions that do not overlap the inorganic layers TL1, TL2, and TL3, and may be portions of the second bank layer BN2 on which the patterning processes of forming the inorganic layers TL1, TL2, and TL3 are repeatedly performed. Accordingly, the fourth bank parts BP4 of the second bank layer BN2 may have a thickness TH4 less than the thicknesses TH1, TH2 and TH3 of the first to third bank parts BP1, BP2, and BP3, and may be the thinnest portion of the second bank layer BN2.

The first bank part BP1 of the second bank layer BN2 may be a portion on which the patterning processes of forming the inorganic layers TL1, TL2, and TL3 are not performed, and the second bank part BP2 may a portion partially etched by performing the patterning process once. The third bank part BP3 of the second bank layer BN2 may be a portion partially etched by performing the patterning processes of forming the inorganic layers TL1, TL2, and TL3 twice, and the fourth bank part BP4 of the second bank layer BN2 may be a portion partially etched by performing the patterning processes three times. In an embodiment, when the processes of forming the respective inorganic layers TL1, TL2, and TL3 are performed under the same patterning process condition, differences between the thicknesses TH1, TH2, TH3, and TH4 of the first bank part BP1 to the fourth bank part BP4 of the second bank layer BN2 may be substantially the same as each other. In an embodiment, for example, a thickness difference (TH1 - TH2) between the first bank part BP1 and the second bank part BP2 may be substantially the same as a thickness difference (TH2 - TH3) between the second bank part BP2 and the third bank part BP3 and a thickness difference (TH3 - TH4) between the third bank part BP3 and the fourth bank part BP4. However, the disclosure is not limited thereto. The thickness differences between the first to fourth bank parts BP1, BP2, BP3, and BP4 may not be substantially the same as each other, and only meaningful thickness differences may exist between the first to fourth bank parts BP1, BP2, BP3, and BP4.

The first to third bank parts BP1, BP2, and BP3 of the second bank layer BN2 may be portions surrounding the openings OPE1, OPE2, and OPE3, respectively, and may be portions in which the tips TIP are formed in the bank structure BNS. The third bank part BP3 having the relatively smallest thickness among the first to third bank parts BP1, BP2, and BP3 may have a minimum thickness enough to maintain at least a shape of the tip TIP. In an embodiment, the thickness TH3 of the third bank part BP3 may be at least about 2500 angstrom (Å) or greater. The thicknesses TH1 and TH2 of the first bank part BP1 and the second bank part BP2 may also be about 2500 Å or greater. However, the disclosure is not limited thereto.

In an embodiment, the first bank layer BN1 of the bank structure BNS may be in direct contact with the common electrodes CE1, CE2, and CE3 of the respective light emitting elements ED1, ED2 and ED3, and the common electrodes CE1, CE2, and CE3 of the different light emitting elements ED1, ED2, and ED3 may be electrically connected to each other through the first bank layer BN1. The first bank layer BN1 may be made of an alloy including aluminium (Al) as a metal material having a good electrical conductivity, and aluminium (Al) may form an oxide film (e.g., aluminium oxide (Al₂O₃) when it is exposed to the outside air due to characteristics of a material. However, in the display device 10, the second bank layer BN2 includes the organic insulating material, such that a baking process may be performed on the second bank layer BN2 during the processes for fabrication of the display device 10, and the first bank layer BN1 may include oxide films in which metal layers having a high conductivity are formed on outer surfaces thereof exposed on side surfaces of the openings OPE1, OPE2, and OPE3. The common electrodes CE1, CE2, and CE3 are in contact with the oxide films formed on the side surfaces of the first bank layer BN1, but may have relatively low contact resistances due to the metal layers formed in the oxide films.

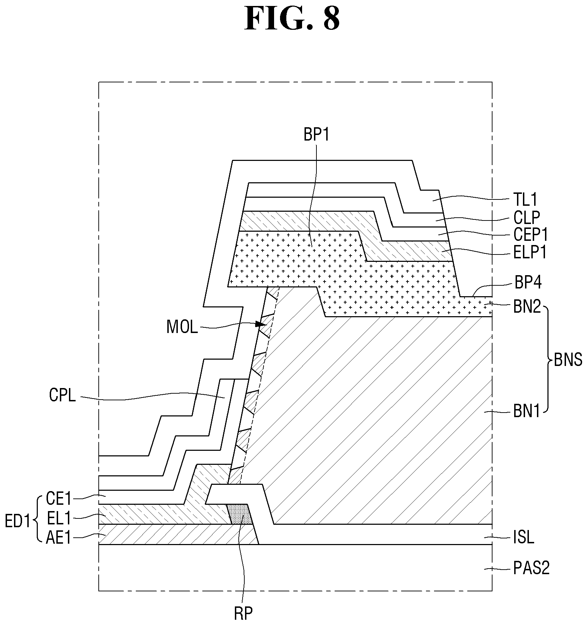

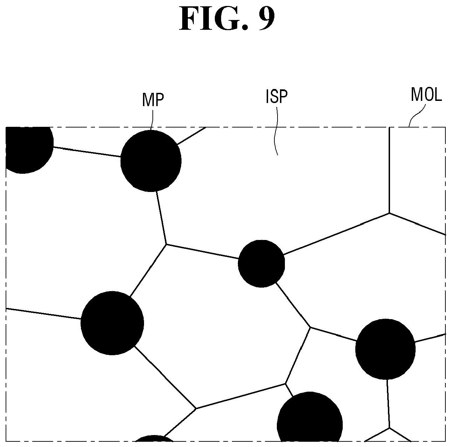

FIG. 8 is an enlarged view illustrating a side surface of a first bank layer in a bank structure of the display device according to an embodiment. FIG. 9 is a schematic view illustrating a surface layer formed on a surface of the first bank layer of FIG. 8.

Referring to FIGS. 8 and 9, in the display device 10 according to an embodiment, the first bank layer BN1 of the bank structure BNS may include metal oxide films MOL formed on the side surfaces defining the openings OPE1, OPE2, and OPE3. The metal oxide film MOL may include insulating parts ISP including or made of a metal oxide and metal crystals MP crystallized by partially precipitating an alloy constituting the first bank layer BN1. The first bank layer BN1 may be a metal layer including or made of an aluminium (Al)-nickel (Ni)-lanthanum (La)-copper (Cu) alloy (AlNiLaCu), and aluminium (Al) included in the alloy may be exposed to the outside air to form aluminium oxide (Al₂O₃). In the metal oxide film MOL of the first bank layer BN1, the insulating parts ISP may be portions formed of aluminium oxide (Al₂O₃). However, when the baking process of the second bank layer BN2 is performed, aluminium (Al), nickel (Ni) and copper (Cu) may form the metal crystals (AlNiCu) MP on the surface of the first bank layer BN1 while being precipitated from the aluminium (Al)-nickel (Ni)-lanthanum (La)-copper (Cu) alloy (AlNiLaCu) of the first bank layer BN1.

The metal crystals MP formed as described above may be portions having a high electrical conductivity in the metal oxide film MOL formed on the surface of the first bank layer BN1. In an embodiment where the common electrodes CE1, CE2, and CE3 of the light emitting elements ED 1, ED2, and ED3 are in contact with the side surfaces of the first bank layer BN1, even though the common electrodes CE1, CE2, and CE3 are in direct contact with the metal oxide films MOL, portions of the common electrodes CE1, CE2, and CE3 may be in contact with the metal crystals MP formed on the surfaces of the metal oxide films MOL. Accordingly, in the display device 10, the first bank layer BN1 may have a lower contact resistance in a case where the metal oxide films MOL is in contact with the common electrodes CE1, CE2, and CE3 than a case where the first bank layer BN1 includes only aluminium (Al). In the display device 10, it is possible to reduce a difference in contact resistance that may occur when the common electrodes CE1, CE2, and CE3 of the different light emitting elements ED1, ED2, and ED3 and the first bank layer BN1 are in contact with each other, and it is possible to reduce a difference in luminance between the different light emitting elements ED1, ED2, and ED3 to prevent a mura from occurring on a screen.

Referring back to FIG. 5, the light blocking layer BM may be disposed on the thin film encapsulation layer TFEL. The light blocking layer BM may include a plurality of holes OPT1, OPT2, and OPT3 disposed to overlap the emission areas EA1, EA2, and EA3. In an embodiment, for example, a first hole OPT1 may be disposed to overlap the first emission area EA1. A second hole OPT2 may be disposed to overlap the second emission area EA2, and a third hole OPT3 may be disposed to overlap the third emission area EA3. An area or a size of each of the holes OPT1, OPT2, and OPT3 may be greater than the area or the size of each of the emission areas EA1, EA2, and EA3 defined by the bank structure BNS. The holes OPT1, OPT2, and OPT3 of the light blocking layer BM are formed to be greater than the emission areas EA1, EA2, and EA3, and accordingly, the light emitted from the emission areas EA1, EA2, and EA3 may be viewed by a user not only from a front surface but also from side surfaces of the display device 10.

The light blocking layer BM may include a light absorbing material. In an embodiment, for example, the light blocking layer BM may include an inorganic black pigment or an organic black pigment. The inorganic black pigment may be carbon black, and the organic black pigment may include at least one selected from lactam black, perylene black, and aniline black, but the disclosure is not limited thereto. The light blocking layer BM may prevent color mixing due to permeation of visible light between the first to third emission areas EA1, EA2, and EA3 to improve a color gamut of the display device 10.

The display device 10 may include a plurality of color filters CF1, CF2, and CF3 disposed on the emission areas EA1, EA2, and EA3. The plurality of color filters CF1, CF2, and CF3 may be disposed to correspond to the emission areas EA1, EA2, and EA3, respectively. In an embodiment, for example, the color filters CF1, CF2, and CF3 may be disposed on the light blocking layer BM including the plurality of holes OPT1, OPT2, and OPT3 disposed to correspond to the emission areas EA1, EA2, and EA3. The holes of the light blocking layer BM may be defined or formed to overlap the emission areas EA1, EA2, and EA3 or the openings of the bank structures BNS, and may form light emitting areas through which the light emitted from the emission areas EA1, EA2, and EA3 is emitted. Each of the color filters CF1, CF2, and CF3 may have a greater area than each of the holes of the light blocking layer BM, and each of the color filters CF1, CF2, and CF3 may completely cover the emission area formed by each of the holes.

The color filters CF1, CF2, and CF3 may include first color filters CF1, second color filters CF2, and third color filters CF3 disposed to correspond to different emission areas EA1, EA2, and EA3, respectively. The color filters CF1, CF2, and CF3 may include colorants such as dyes or pigments absorbing light of wavelength bands other than light of a specific wavelength band, and may be disposed to correspond to the colors of the light emitting from the emission areas EA1, EA2, and EA3. In an embodiment, for example, the first color filter CF1 may be a red color filter disposed to overlap the first emission area EA1 and transmitting only the first light, which is the red light, therethrough. The second color filter CF2 may be a green color filter disposed to overlap the second emission area EA2 and transmitting only the second light, which is the green light, therethrough, and the third color filter CF3 may be a blue color filter disposed to overlap the third emission area EA3 and transmitting only the third light, which is the blue light, therethrough.

The plurality of color filters CF1, CF2, and CF3 may be spaced apart from other adjacent color filters CF1, CF2, and CF3 on the light blocking layer BM. The color filters CF1, CF2, and CF3 may have greater areas than the holes OPT1, OPT2, and OPT3 of the light blocking layer BM while covering the holes OPT1, OPT2, and OPT3 of the light blocking layer BM, respectively, but may have areas enough to be spaced apart from other color filters CF1, CF2, and CF3 on the light blocking layer BM. However, the present disclosure is not limited thereto. The plurality of color filters CF1, CF2, and CF3 may be disposed to partially overlap other adjacent color filters CF1, CF2, and CF3. Different color filters CF1, CF2, and CF3 may overlap each other on a light blocking layer BM to be described later, which is an area that does not overlap the emission areas EA1, EA2, and EA3. In the display device 10, the color filters CF1, CF2, and CF3 are disposed to overlap each other, such that an intensity of reflected light by external light may be reduced. Furthermore, a color feeling of the reflected light by the external light may be controlled by adjusting a layout, a shape, areas, and the like, of the color filters CF1, CF2, and CF3 in a plan view.

The color filters CF1, CF2, and CF3 of the color filter layer CFL may be disposed on the light blocking layer BM. The different color filters CF1, CF2, and CF3 may be disposed to correspond to the different emission areas EA1, EA2, and EA3 or openings OPE1, OPE2, and OPE3 and the holes OPT1, OPT2, and OPT3 of the light blocking layer BM, respectively. In an embodiment, for example, the first color filter CF1 may be disposed to correspond to the first emission area EA1, the second color filter CF2 may be disposed to correspond to the second emission area EA2, and the third color filter CF3 may be disposed to correspond to the third emission area EA3. The first color filter CF1 may be disposed in the first hole OPT1 of the light blocking layer BM, the second color filter CF2 may be disposed in the second hole OPT2 of the light blocking layer BM, and the third color filter CF3 is disposed in the third hole OPT3 of the light blocking layer BM. Each of the color filters CF1, CF2, and CF3 may be disposed to have a greater area than each of the holes OPT1, OPT2, and OPT3 of the light blocking layer BM in a plan view, and portions of each of the color filters CF1, CF2, and CF3 may be directly disposed on the light blocking layer BM.

An overcoat layer OC may be disposed on the color filters CF1, CF2, and CF3 to planarize upper ends of the color filters CF1, CF2, and CF3. The overcoat layer OC may be a colorless light transmitting layer that does not have a color of a visible light band. In an embodiment, for example, the overcoat layer OC may include a colorless light transmitting organic material such as an acrylic resin.

Hereinafter, processes for fabrication of the display device 10 according to an embodiment will be described with reference to other drawings.

FIGS. 10 to 19 are cross-sectional views sequentially illustrating processes for fabrication of the display device according to an embodiment. In FIGS. 10 to 19, processes of forming the bank structure BNS and the light emitting elements ED as the light emitting element layer EML of the display device 10 and the thin film encapsulation layer TFEL are schematically illustrated. Hereinafter, respective layers formed in the processes for fabrication of the display device 10 shown in FIGS. 10 to 19 are substantially the same as those described above. Accordingly, any repetitive detailed description of the respective layers formed in the processes for fabrication of the display device 10 will be omitted, and the order of forming the respective layers will be described.

Referring to FIG. 10, a plurality of pixel electrodes AE1, AE2, and AE3, the sacrificial layer SFL, the inorganic insulating layer ISL, a first bank material layer BNL1, and an organic insulating layer OL are formed on the thin film transistor layer TFTL.

Although not illustrated in FIG. 10, the thin film transistor layer TFTL may be disposed on the substrate SUB, and a structure of the thin film transistor TFTL is the same as that described above with reference to FIG. 5. Accordingly, any repetitive detailed description thereof will be omitted.

The plurality of pixel electrodes AE1, AE2, and AE3 may be disposed to be spaced apart from each other on the thin film transistor layer TFTL. The pixel electrodes AE1, AE2, and AE3 may include the first pixel electrode AE1, the second pixel electrode AE2, and the third pixel electrode AE3 of the different light emitting elements ED1, ED2, and ED3. The first to third pixel electrodes AE1, AE2, and AE3 may be disposed to be spaced apart from each other on the thin film transistor layer TFTL.

The sacrificial layer SFL may be provided on the pixel electrodes AE1, AE2, and AE3. The sacrificial layer SFL may be formed on the pixel electrodes AE1, AE2, and AE3, and then partially removed in a subsequent process to form spaces in which the light emitting layers EL1, EL2, and EL3 are disposed. The sacrificial layer SFL may prevent the upper surfaces of the pixel electrodes AE1, AE2, and AE3 from being in contact with the inorganic insulating layer ISL, and may be removed to form spaces between the pixel electrodes AE1, AE2, and AE3 and the inorganic insulating layer ISL. In an embodiment, the sacrificial layer SFL may include an oxide semiconductor. In an embodiment, for example, the sacrificial layer SFL may include at least one selected from indium gallium zinc oxide (IGZO), zinc tin oxide (ZTO), and indium tin oxide (IZO).

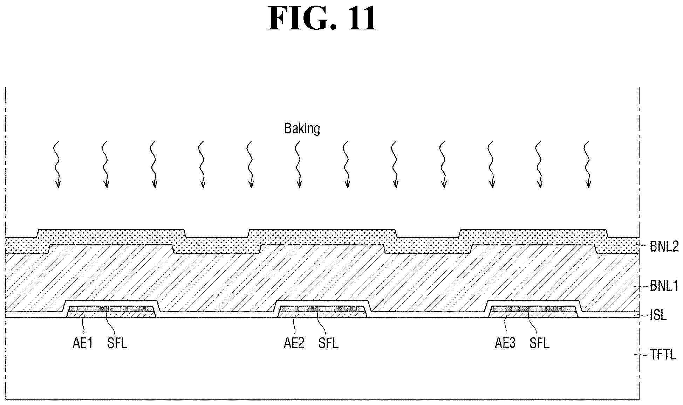

The inorganic insulating layer ISL, the first bank material layer BNL1, and the organic insulating layer OL may be provided on the sacrificial layer SFL. The inorganic insulating layer ISL may be provided to entirely cover the sacrificial layer SFL and the thin film transistor layer TFTL, and the first bank material layer BNL1 may be provided to entirely cover the inorganic insulating layer ISL. The organic insulating layer OL may be provided on the first bank material layer BNL1. The organic insulating layer OL includes an organic insulating material and is applied onto the first bank material layer BNL1, and is baked (see FIG. 11) in a subsequent process to form a second bank material layer BNL2. The bank material layers BNL1 and BNL2 may be partially etched in a subsequent process to form the bank layers BN1 and BN2 of the bank structure BNS illustrated in FIGS. 5 to 7, respectively. The first bank material layer BNL1 may include an aluminium (Al)-nickel (Ni)-lanthanum (La)-copper (Cu) alloy (AlNiLaCu) to form the first bank layer BN1, and the second bank material layer BNL2 may include an organic insulating material such as PI to form the second bank layer BN2.

Next, referring to FIG. 11, the organic insulating layer OL is baked to form the second bank material layer BNL2. The organic insulating layer OL may include a material such as PI like the second bank layer BN2, as an organic insulating material that is not baked. The organic insulating layer OL applied onto the first bank material layer BNL1 in a state in which it has fluidity may be cured through the baking process to form the second bank material layer BNL2. In an embodiment, the baking process of the organic insulating layer OL may be performed at a temperature in a range of about 200 °C to about 300 °C (e.g., about 250 °C) for 30 minutes to 2 hours or about 1 hour. However, the disclosure is not limited thereto. Process conditions of the baking process may change depending on a material of the organic insulating layer OL, an amount of the organic insulating layer OL applied onto the first bank material layer BNL1, and the like.

In the baking process, aluminium (Al)-nickel (Ni)-copper (Cu) metal crystals (AlNiCu) may be precipitated in the first bank material layer BNL1. In the first bank layer BN1 formed by the first bank material layer BNL1, the aluminium (Al)-nickel (Ni)-copper (Cu) metal crystals (AlNiCu) may be formed in the metal oxide film MOL formed on the surface of the first bank layer BN1.

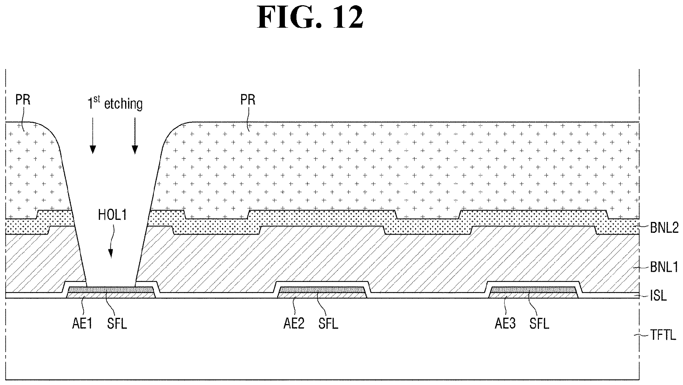

Next, referring to FIG. 12, a photoresist PR is formed on the bank material layers BNL1 and BNL2, and a first etching process (1^{st} etching) of etching portions of the bank material layers BNL1 and BNL2 using the photoresist PR as a mask is performed to form a first hole HOL1.

The photoresists PR may be disposed to be spaced apart from each other on the bank material layers BNL1 and BNL2. The photoresists PR may be disposed on the second bank material layer BNL2 to expose a portion overlapping the first pixel electrode AE1.

In an embodiment, a dry etching process may be performed as the first etching process (1^{st} etching). Since the dry etching process is performed as the first etching process (1^{st} etching), the bank material layers BNL1 and BNL2 including different materials from each other may be anisotropically etched. In this process, portions of the bank material layers BNL1 and BNL2 and the inorganic insulating layer ISL may be etched together to partially expose the sacrificial layer SFL disposed therebelow. The first hole HOL1 may be formed in an area overlapping the pixel electrode AE1, AE2, and AE3, and the first hole HOL1 may form the openings OPE1, OPE2, and OPE3 of the bank structure BNS.

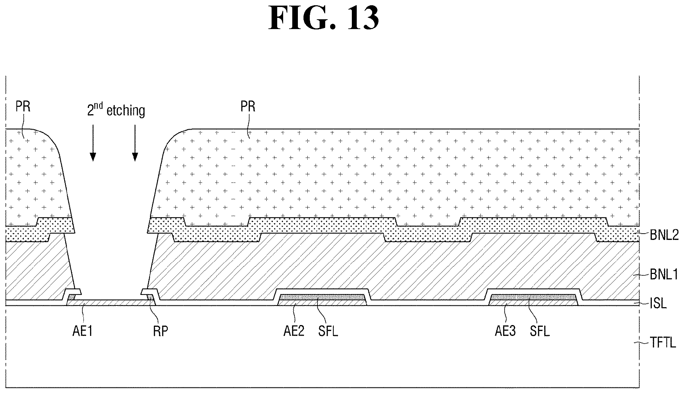

Next, referring to FIG. 13, a second etching process (2^{nd} etching) of removing the sacrificial layer SFL disposed on the first pixel electrode AE1 is performed. In an embodiment, the sacrificial layer SFL may include an oxide semiconductor layer, and a wet etching process is performed as the second etching process (2^{nd} etching). In this process, the bank material layers BNL1 and BNL2 may be isotropically etched in the first hole HOL1 while the sacrificial layer SFL is removed. The first bank material layer BNL1 of the plurality of bank material layers BNL1 and BNL2 may have a faster etch rate than the second bank material layer BNL2, and the second bank material layer BNL2 has a tip TIP formed to protrude more than a side of the first bank material layer BNL1. The side of the first bank material layer BNL1 may have an undercut formed under the tip TIP of the second bank material layer BNL2. The first hole HOL1 may form the first opening OPE1 or the first emission area EA1 by the second etching process (2^{nd} etching).

A portion of the sacrificial layer SFL exposed by the first hole HOL1 and a portion of the sacrificial layer SFL between the inorganic insulating layer ISL and the first pixel electrode AE1 may be removed. However, the sacrificial layer SFL may not be completely removed, and remain as a partial residual pattern RP between the inorganic insulating layer ISL and the pixel electrode AE1. A space may be formed between the first pixel electrode AE1 and the inorganic insulating layer ISL disposed above the first pixel electrode AE1, after the sacrificial layer SFL is removed. In a subsequent process, the first light emitting layer EL1 disposed on the first pixel electrode AE1 may be formed to fill the space.

Next, although not illustrated in the drawings, a strip process of removing the photoresist PR may be performed. In this process, residual traces remaining after being patterned in the second bank material layer BNL2 including the organic insulating material may be removed together, and the tip TIP formed by the second bank material layer BNL2 may remain on a side surface of the first opening OPE1 while maintaining its shape.

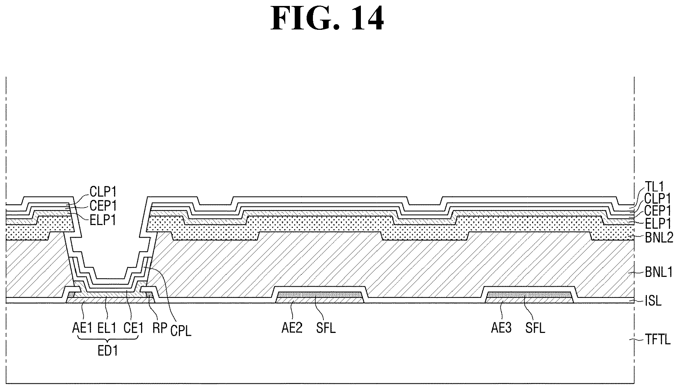

Next, referring to FIG. 14, the first light emitting element ED1 is formed by depositing the first light emitting layer EL1 and the first common electrode CE1 on the first pixel electrode AE1, and the capping layer CPL and the first inorganic layer TL1 are deposited on the first light emitting element ED1 and the bank material layers BNL1 and BNL2. The first light emitting layer EL1 and the first common electrode CE1 may be formed in the first opening OPE1, and materials forming the first light emitting layer EL1 and the first common electrode CE1 may also be deposited on the bank material layer BNL2 in the deposition process to form a plurality of patterns. In an embodiment, for example, portions of such materials may be deposited on the second bank material layer BNL2 to form the first organic pattern ELP1 and the first electrode pattern CEP1, a portion of the capping layer CPL may be disposed in the first opening OPE1 to cover the first light emitting element ED1, and the other portion of the capping layer CPL may be disposed on the second bank material layer BNL2 to cover the first organic pattern ELP1 and the first electrode pattern CEP1. In such an embodiment, structures of the first light emitting layer EL 1, the first common electrode CE1, and the first organic pattern ELP1, and the first electrode pattern CEP1 is the same as those described above.

In an embodiment, the first light emitting layer EL1 and the first common electrode CE1 may be formed through deposition processes. Deposition of the materials may not be smooth in the first opening OPE1 due to the tip TIP of the second bank material layer BNL2. In such an embodiment, the materials of the first light emitting layer EL1 and the first common electrode CE1 are deposited in a direction inclined with the upper surface of the substrate rather than in the direction perpendicular to the upper surface of the substrate, and may thus be deposited in an area hidden by (or immediately below) the tip TIP of the second bank material layer BNL2.

In an embodiment, for example, the deposition process of forming the first light emitting layer EL1 may be performed so that the materials are deposited in a direction that is not perpendicular to an upper surface of the first pixel electrode AE1, for example, in a direction inclined with respect to the upper surface of the first pixel electrodes AE1 at a first angle. In an embodiment, in a process of forming the light emitting layers EL1, EL2, and EL3, deposition of the materials may be performed at an inclined angle of about 45° to about 50° from the upper surface of the pixel electrodes AE1, AE2, and AE3. The first light emitting layer EL1 may be formed to fill the space between the first pixel electrode AE1 and the inorganic insulating layer ISL, and may also be formed in an area hidden by the tip TIP of the second bank material layer BNL2. In an embodiment, for example, the first light emitting layer EL1 may be partially disposed on a side surface of the first bank material layer BNL1, which is the area hidden by the tip TIP.

The deposition process of forming the first common electrode CE1 may be performed so that the materials are deposited in a direction that is not perpendicular to the upper surface of the first pixel electrode AE1, for example, in a direction inclined with respect to the upper surface of the first pixel electrodes AE1 at a second angle. In an embodiment, in a process of forming the common electrodes CE1, CE2, and CE3, deposition of the materials may be performed at an inclined angle of about 30° or less from the upper surface of the pixel electrodes AE1, AE2, and AE3. The first common electrode CE1 may be disposed on the first light emitting layer EL1, and may also be formed in the area hidden by the tip TIP of the second bank material layer BNL2. In an embodiment, for example, the first common electrode CE1 may be partially disposed on the side surface of the first bank material layer BNL1, which is the area hidden by the tip TIP.

The deposition process of forming the common electrodes CE1, CE2, and CE3 may be performed in an inclined direction relatively closer to a horizontal direction than the deposition process of forming the light emitting layers EL1, EL2, and EL3. Accordingly, the common electrodes CE1, CE2, and CE3 may be in contact with side surfaces of the first bank material layer BNL1 or the first bank layer BN1 in a greater area than the light emitting layers EL1, EL2, and EL3. Alternatively, the common electrodes CE1, CE2, and CE3 may be deposited up to a higher position on the side surfaces of the first bank material layer BNL1 or the first bank layer BN1 than the light emitting layers EL1, EL2, and EL3. The different common electrodes CE1, CE2, and CE3 may be in contact with the first bank material layer BNL1 or the first bank layer BN1 having a high conductivity to be electrically connected to each other.

The first inorganic layer TL1 may be formed by a chemical vapor deposition (CVD) process unlike the light emitting layers EL1, EL2, and EL3 and the common electrodes CE1, CE2, and CE3, and may form a uniform film regardless of a step of a portion on which the first organic layer TL1 is deposited. The first inorganic layer TL1 may be formed to completely cover outer surfaces of the first light emitting element ED1, the bank material layers BNL1 and BNL2, and the capping layer CPL. In such an embodiment, the first inorganic layer TL1 may also be deposited under the tip TIP of the second bank material layer BNL2.

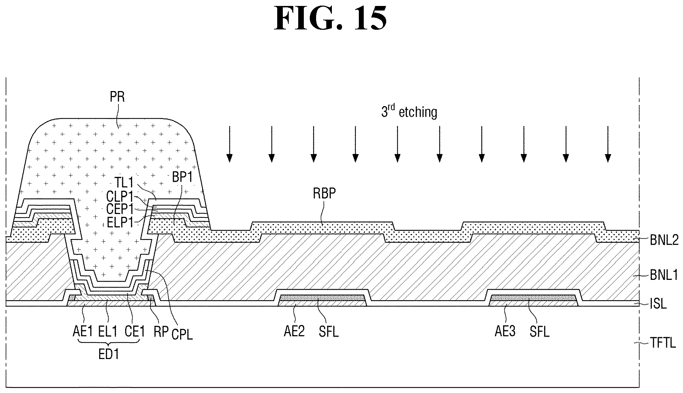

Next, referring to FIG. 15, a photoresist PR is formed on the first inorganic layer TL1, and a third etching process (3^{rd} etching) of removing portions of the first organic pattern ELP1, the first electrode pattern CEP1, the capping layer CPL, and the first inorganic layer TL1 disposed on the bank material layers BNL1 and BNL2 is performed. According to an embodiment, a dry etching process using a fluorine (F)-based etchant may be performed as the third etching process (3^{rd} etching) of removing the first inorganic layer TL1 disposed on the bank material layers BNL1 and BNL2. The third etching process (3^{rd} etching) may be performed using an etchant capable of removing at least the first inorganic layer TL1.

In this process, the photoresist PR may be disposed to overlap the first opening OPE1 or the first light emitting element ED1. The first organic pattern ELP1, the first electrode pattern CEP1, the capping pattern CLP, and the first inorganic layer TL1 disposed on the bank material layers BNL1 and BNL2 may be entirely removed except for a portion around the first opening OPE1 or the first light emitting element ED1. In this process, an area of the second bank material layer BNL2 except for the portion around the first opening OPE1 or the first light emitting element ED1 may be exposed. A portion of the second bank material layer BNL2 overlapping the first organic pattern ELP1, the first electrode pattern CEP1, the capping pattern CLP, and the first inorganic layer TL1 may not be etched in the third etching process (3^{rd} etching), and may become the first bank part BP1 of the second bank layer BN2. A residual portion RBP of the second bank material layer BNL2 exposed by the removal of the first inorganic layer TL1 may be partially etched in the third etching process (3^{rd} etching). Accordingly, the first bank part BP1 of the second bank layer BN2 may become a portion having the greatest thickness, and a thickness of the residual portion RBP may become less than that of the first bank part BP1 by the third etching process (3^{rd} etching).

Through the above processes, the first light emitting element ED1 and the first inorganic layer TL1 covering the first light emitting element ED1, the first organic pattern ELP1, the first electrode pattern CEP1, and the capping layer CPL may be formed.

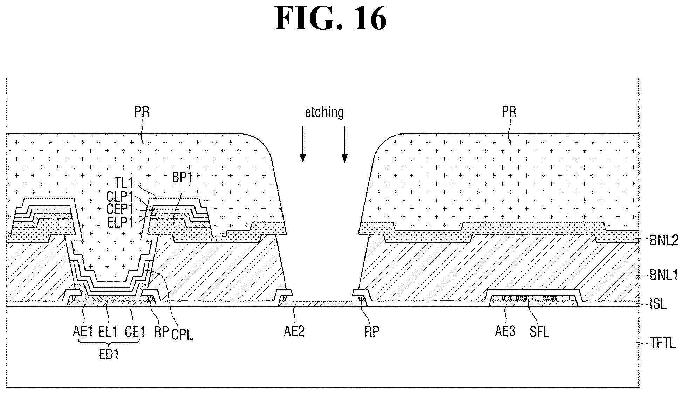

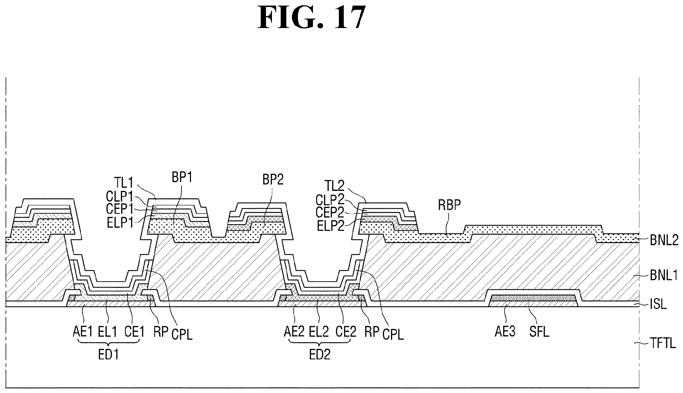

Next, referring to FIGS. 16 and 17, the second light emitting element ED2, the second organic pattern ELP2, the second electrode pattern CEP2, and the second inorganic layer TL2 are formed by repeating processes similar to the above-described processes. As described above, the first etching process (1^{st} etching) of forming the photoresist PR on the first bank material layer BNL1 and the second bank material layer BNL2 and forming the first hole HOL1, the second etching process (2^{nd} etching) of removing the sacrificial layer SFL exposed by the first hole HOL1, and the strip process of removing the photoresist PR may be performed. In this process, the photoresist PR may be formed to cover the first light emitting element ED1 and the first inorganic layer TL1. The second light emitting element ED2 may be formed in an opening formed in the second etching process (2^{nd} etching), the second inorganic layer TL2 may be formed on the second light emitting element ED2, and a third etching process (3^{rd} etching) of etching and removing a portion of the second inorganic layer TL2 may then be performed.

A portion of the second bank material layer BNL2 overlapping the second organic pattern ELP2, the second electrode pattern CEP2, the capping pattern CLP, and the second inorganic layer TL2 may not be etched in the third etching process (3^{rd} etching), and may become the second bank part BP2 of the second bank layer BN2. A residual portion RBP of the second bank material layer BNL2 exposed by the removal of the second inorganic layer TL2 may be partially etched in the third etching process (3^{rd} etching). Accordingly, the residual portion RBP of the second bank layer BN2 is etched once more in a process of forming the second inorganic layer TL2 after the formation of the first inorganic layer TL1, such that a thickness of the residual portion RBP may become less than that of the second bank part BP2.

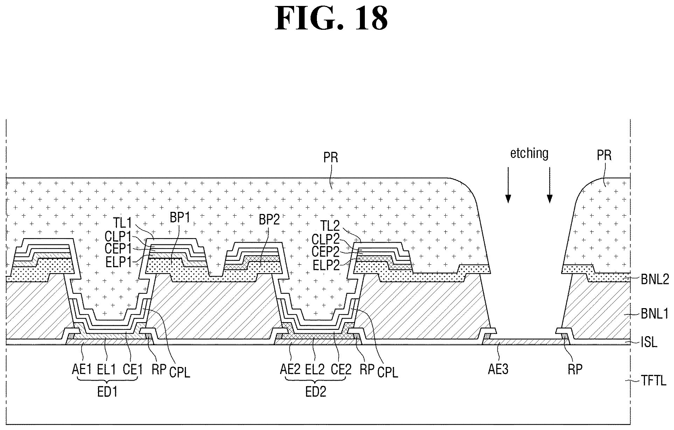

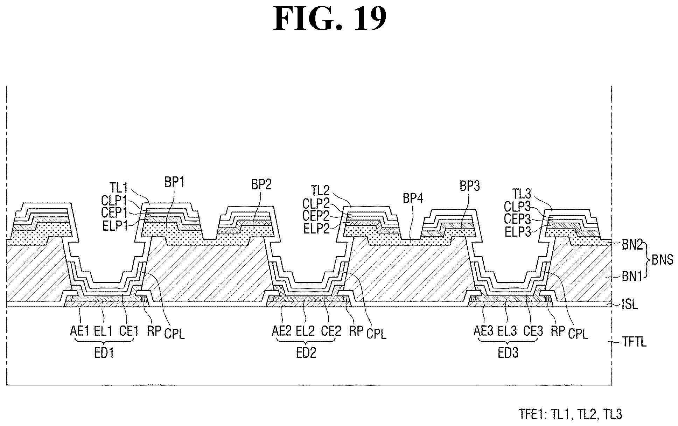

Next, referring to FIGS. 18 and 19, the third light emitting element ED3, the third organic pattern ELP3, the third electrode pattern CEP3, and the third inorganic layer TL3 are formed by repeating processes similar to the above-described processes. As described above, the first etching process (1^{st} etching) of forming the photoresist PR on the first bank material layer BNL1 and the second bank material layer BNL2 and forming the first hole HOL1, the second etching process (2^{nd} etching) of removing the sacrificial layer SFL exposed by the first hole HOL1, and the strip process of removing the photoresist PR may be performed. In this process, the photoresist PR may be formed to cover the first light emitting element ED1, the first inorganic layer TL1, the second light emitting element ED2, and the second inorganic layer TL2. The third light emitting element ED3 may be formed in an opening formed in the second etching process (2^{nd} etching), the third inorganic layer TL3 may be formed on the third light emitting element ED3, and a third etching process (3^{rd} etching) of etching and removing a portion of the third inorganic layer TL3 may then be performed.

A portion of the second bank material layer BNL2 overlapping the third organic pattern ELP3, the third electrode pattern CEP3, the capping pattern CLP, and the third inorganic layer TL3 may not be etched in the third etching process (3^{rd} etching), and may become the third bank part BP3 of the second bank layer BN2. Residual portions RBP of the second bank material layer BNL2 exposed by the removal of the third inorganic layer TL3 may be partially etched in the third etching process (3^{rd} etching), and may become the fourth bank parts BP4 of the second bank layer BN2. Accordingly, the fourth bank parts BP4 of the second bank layer BN2 are etched once more in a process of forming the third inorganic layer TL3 after the formation of the second inorganic layer TL2, such that a thickness of the fourth bank parts BP4 may become less than that of the third bank part BP3.

Accordingly, the second bank layer BN2 of the bank structure BNS of the display device 10 may accordingly have a shape in which a thickness thereof changes depending on positions. The first to third bank parts BP1, BP2, and BP3 of the second bank layer BN2 surrounding the respective openings OPE1, OPE2, and OPE3 and forming the tips TIP on sidewalls defining the respective openings OPE1, OPE2, and OPE3 may have different thicknesses. In addition, the second bank layer BN2 may include the fourth bank parts BP4 that do not overlap the inorganic layers TL1, TL2, and TL3 between the first to third bank parts BP1, BP2, and BP3, and have the smallest thickness. However, since the second bank layer BN2 includes the organic insulating material, even though repeated etching processes are performed, the third bank part BP3 having the smallest thickness among the first to third bank parts BP1, BP2, and BP3 may also have a thickness enough to prevent the tip TIP from sagging. Accordingly, in the processes of forming the light emitting elements ED1, ED2, and ED3 in the openings OPE1, OPE2, and OPE3 in which the tips TIP are formed, the common electrodes CE1, CE2, and CE3 may be formed to be in sufficient contact with the side surfaces of the first bank layer BN1. Since the display device 10 includes the bank structure BNS having the uniformly formed tips TIP, the processes for fabrication of the display device 10 may be simplified, and high electrical connection between the common electrodes CE1, CE2, and CE3 may be secured, such that a difference in luminance between the respective light emitting elements ED1, ED2, and ED3 may be reduced.

Next, although not illustrated in the drawings, the display device 10 is fabricated by forming the second encapsulation layer TFE2 and the third encapsulation layer TFE3 of the thin film encapsulation layer TFEL, the light blocking layer BM, the color filter layer CFL, and the overcoat layer OC on the light emitting elements ED1, ED2, and ED3, and the bank structure BNS. Structures of the thin film encapsulation layer TFEL, the light blocking layer BM, the color filter layer CFL, and the overcoat layer OC are the same as those described above, and any repetitive detailed description thereof will thus be omitted.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a first pixel electrode and a second pixel electrode which are disposed on a substrate to be spaced apart from each other;
an inorganic insulating layer disposed on the substrate to partially cover the first pixel electrode and the second pixel electrode;
a bank structure disposed on the inorganic insulating layer, wherein a first opening overlapping the first pixel electrode and a second opening overlapping the second pixel electrode are defined through the bank structure;
a first light emitting layer disposed on the first pixel electrode and a second light emitting layer disposed on the second pixel electrode; and
a first common electrode disposed on the first light emitting layer, and a second common electrode disposed on the second light emitting layer,
wherein the bank structure includes a first bank layer and a second bank layer disposed on the first bank layer,
the second bank layer includes an organic insulating material different from a material of the first bank layer and has different thicknesses depending on positions thereof,
the second bank layer includes tips protruding more than side surfaces of the first bank layer defining the first opening and the second opening, and
the first bank layer includes an aluminium (Al)-nickel (Ni)-lanthanum (La)-copper (Cu) alloy (AINiLaCu).

2. The display device of claim 1, wherein the first common electrode and the second common electrode are in direct contact with the side surfaces of the first bank layer, respectively.

3. The display device of claim 2, wherein
the first bank layer includes metal oxide films formed at side surfaces thereof defining the first opening and the second opening, and
the metal oxide films include metal crystals formed at surfaces thereof and including an aluminium (Al)-nickel (Ni)-copper (Cu) alloy.

4. The display device of any one of claims 1 to 3, wherein
the second bank layer includes a first bank part positioned around the first opening and a second bank part positioned around the second opening, and
the first bank part has a thickness greater than a thickness of the second bank part.

5. The display device of claim 4, wherein a tip of the second bank layer corresponding to the first opening has a thickness greater than a thickness of a tip of the second bank layer corresponding to the second opening.

6. The display device of claim 4 or claim 5, further comprising:
a third pixel electrode disposed to be spaced apart from the second pixel electrode on the sub strate;
a third light emitting layer disposed on the third pixel electrode; and
a third common electrode disposed on the third light emitting layer,
wherein a third opening overlapping the third pixel electrode is further defined in the bank structure, and
the second bank layer further includes a third bank part positioned around the third opening and having a thickness less than a thickness of the second bank part.

7. The display device of claim 6, wherein a thickness difference between the first bank part and the second bank part is substantially the same as a thickness difference between the second bank part and the third bank part.

8. The display device of claim 6 or claim 7, wherein the second bank layer further includes fourth bank parts disposed between the first bank part, the second bank part, and the third bank part and having a thickness less than the thickness of the third bank part.

9. The display device of any one of claims 4 to 8, further comprising:
a first organic pattern disposed on the first bank part and including a same material as the first light emitting layer;
a first electrode pattern disposed on the first organic pattern and including a same material as the first common electrode;
a second organic pattern disposed on the second bank part and including a same material as the second light emitting layer; and
a second electrode pattern disposed on the second organic pattern and including a same material as the second common electrode, optionally wherein:
the display device further comprises:
a first inorganic layer disposed on the side surfaces of the first bank layer defining the first opening and disposed on the first common electrode and the first electrode pattern; and
a second inorganic layer disposed on the side surfaces of the first bank layer defining the second opening and disposed on the second common electrode and the second electrode pattern,
wherein the first inorganic layer and the second inorganic layer are disposed to be spaced apart from each other, and
portions of the second bank layer do not overlap the first inorganic layer and the second inorganic layer.

10. The display device of any one of claims 1 to 9, wherein
the inorganic insulating layer is not in contact with each of upper surfaces of the first pixel electrode and the second pixel electrode,
a portion of the first light emitting layer is disposed between the first pixel electrode and the inorganic insulating layer, and
a portion of the second light emitting layer is disposed between the second pixel electrode and the inorganic insulating layer, optionally wherein:
the display device further comprises:
residual patterns disposed between the first pixel electrode and the inorganic insulating layer and between the second pixel electrode and the inorganic insulating layer.

11. The display device of any one of claims 1 to 10, further comprising:
a thin film encapsulation layer disposed on the bank structure,
wherein the thin film encapsulation layer includes a first encapsulation layer, a second encapsulation layer disposed on the first encapsulation layer, and a third encapsulation layer disposed on the second encapsulation layer, optionally wherein:
the display device further comprises:
a light blocking layer disposed on the third encapsulation layer, wherein a plurality of opening holes overlapping the first and second openings is defined through the light blocking layer;
a first color filter disposed on the light blocking layer and overlapping the first opening; and
a second color filter disposed on the light blocking layer and overlapping the second opening.

12. A method for fabrication of a display device, the method comprising:
forming a plurality of pixel electrodes spaced apart from each other on a substrate, forming a sacrificial layer on the pixel electrodes, forming an inorganic insulating layer on the sacrificial layer, forming a first bank material layer on the inorganic insulating layer, and forming an organic insulating layer on the first bank material layer;
forming a second bank material layer on the first bank material layer by baking the organic insulating layer;
forming a first hole through the first bank material layer and the second bank material layer to expose a portion of the sacrificial layer disposed on a pixel electrode of the pixel electrodes;
wet-etching the sacrificial layer and side surfaces of the first bank material layer and the second bank material layer defining the first hole to remove the sacrificial layer and to form a tip of the second bank material layer protruding more than an etched side surface of the first bank material layer;
forming a light emitting layer and a common electrode on the pixel electrode in a first opening formed by wet-etching the first hole and forming an inorganic layer on the common electrode and the second bank material layer; and
removing a portion of the inorganic layer disposed on the second bank material layer,
wherein in the removing the portion of the inorganic layer, a portion of the second bank material layer is etched to have a decreased thickness.

13. The method of claim 12, wherein
the first bank material layer includes an aluminium (Al)-nickel (Ni)-lanthanum (La)-copper (Cu) alloy (AlNiLaCu), and
the second bank material layer includes an organic insulating material.

14. The method of claim 13, wherein:
(i) a process of baking the organic insulating layer is performed in a temperature range of about 200 °C to about 300 °C for 30 minutes to 2 hours; and/or
(ii) the first bank material layer includes a metal oxide film formed on a side surface thereof defining the first opening, and
the metal oxide film includes metal crystals formed at a surface thereof and including an aluminium (Al)-nickel (Ni)-copper (Cu) alloy.

15. The method of any one of claims 12 to 14, wherein in the forming the light emitting layer and the common electrode, an organic pattern including a same material as the light emitting layer is formed on the second bank material layer, and an electrode pattern including a same material as the common electrode are formed on the organic pattern, and the inorganic layer is disposed on the electrode pattern, optionally wherein:
the second bank material layer includes a bank part overlapping the organic pattern and the electrode pattern and a residual portion which is a portion other than the bank part and exposed by removing a portion of the inorganic layer, and
in the removing the portion of the inorganic layer, the residual portion is etched to have a thickness less than a thickness of the bank part.
